# EUROPEAN PATENT SPECIFICATION

(11) **EP 4 325 572 B1**
(45) Date of publication and mention of the grant of the patent: **12.03.2025**
(21) Application number: 23190351.9
(22) Date of filing: 08.08.2023
(51) Int. Cl.: H01L 27/146

(54) **IMAGE SENSOR INCLUDING PATTERNED ANTIREFLECTION LAYER AND ELECTRONIC APPARATUS INCLUDING THE SAME**
BILDSENSOR MIT STRUKTURIERTER ANTIREFLEXIONSSCHICHT UND ELEKTRONISCHE VORRICHTUNG DAMIT
CAPTEUR D'IMAGE COMPRENANT UNE COUCHE ANTIREFLET À MOTIFS ET APPAREIL ÉLECTRONIQUE LE COMPRENANT

(30) Priority: 18.08.2022 KR 20220103478
(43) Date of publication of application: 21.02.2024
(73) Proprietor: Samsung Electronics Co., Ltd., Suwon-si, Gyeonggi-do 16677 (KR)
(72) Inventor: MUN, Sangeun, Suwon-si, Gyeonggi-do 16678 (KR); ROH, Sookyoung, Suwon-si, Gyeonggi-do 16678 (KR); AHN, Sungmo, Suwon-si, Gyeonggi-do 16678 (KR); PARK, Hyunsung, Suwon-si, Gyeonggi-do 16678 (KR); YUN, Seokho, Suwon-si, Gyeonggi-do 16678 (KR); LEE, Sangyun, Suwon-si, Gyeonggi-do 16678 (KR); LEE, Junho, Suwon-si, Gyeonggi-do 16678 (KR); CHO, Choonlae, Suwon-si, Gyeonggi-do 16678 (KR)
(74) Representative: Elkington and Fife LLP

(56) References cited:
- KR-A- 20220 058 388
- US-A1- 2022 208 822

## Description

### FIELD OF THE INVENTION

The disclosure relates to an image sensor including a patterned antireflection layer and an electronic apparatus including the image sensor.

### BACKGROUND OF THE INVENTION

An image sensor typically senses the color of incident light by using a color filter. However, because the color filter absorbs light of a color other than light of a corresponding color, a light use efficiency may be reduced. For example, when an RGB color filter is used, because the RGB color filter transmits only 1/3 of an incident light and absorbs the remaining 2/3, the light use efficiency is merely about 33%. Accordingly, in a color display device or a color image sensor, most of light loss occurs in the color filter. In addition, because the image sensor includes several layers having different refractive indices, the incident light may be reflected from boundaries between the layers. In order to increase the light use efficiency of the image sensor, an image sensor may have a low reflectance with respect to incident light.

Document KR 2022 0058388 A shows an image sensor according to the prior-art.

### SUMMARY OF THE INVENTION

One or more example embodiments provide an image sensor including a patterned antireflection layer.

In addition, one more example embodiments provide an electronic apparatus including an image sensor.

Additional aspects will be set forth in part in the description which follows and, in part, will be apparent from the description, or may be learned by practice of the presented embodiments of the disclosure.

According to an aspect of the disclosure, an image sensor includes: a sensor substrate including a plurality of first pixels configured to sense light having a first wavelength and a plurality of second pixels configured to sense light having a second wavelength that is different from the first wavelength; a nano-photonic lens array having a light incident surface and including a plurality of nanostructures configured to condense an incident light onto the plurality of first pixels and the plurality of second pixels; and an antireflection layer disposed on the light incident surface of the nano-photonic lens array and including a plurality of holes arranged periodically and two-dimensionally, wherein the plurality of holes includes: a plurality of first holes provided at positions corresponding to a boundary between first pixels, among the plurality of first pixels, and second pixels, among the plurality of second pixels, that are adjacent to the first pixels; and a plurality of second holes facing an inner region of at least one of a first pixel of the plurality of first pixels or a second pixel of the plurality of second pixels.

A center of each of the plurality of first holes is positioned above the boundary between the first pixels and second pixels that are adjacent to the first pixels.

Each of the plurality of holes may have a same width.

A second hole facing the first pixel, among the plurality of second holes, may have a first width, a second hole facing the second pixel, among the plurality of second holes, may have a second width different from the first width, and the plurality of first holes may have the first width or the second width.

A distance between adjacent holes of the plurality of holes may be the same.

The first wavelength may be greater than the second wavelength, and the first width may be less than the second width.

An average refractive index of the antireflection layer may be greater than a refractive index of air and less than an average refractive index of the nano-photonic lens array.

The antireflection layer may include: a first antireflection layer disposed on the light incident surface of the nano-photonic lens array; and a second antireflection layer disposed on the first antireflection layer, and the second antireflection layer may be patterned to include the plurality of holes.

The first antireflection layer may have a first refractive index, the second antireflection layer has a second refractive index, and the first refractive index may be higher than the second refractive index.

The first antireflection layer may be at least partially patterned to include the plurality of holes.

The antireflection layer may include an inorganic material having a refractive index that may be equal to or greater than about 1 and equal to or less than about 3.

The nano-photonic lens array may include a plurality of first lenses facing the plurality of first pixels and a plurality of second lenses facing the plurality of second pixels, and the plurality of nanostructures may be configured to condense light of the first wavelength among an incident light incident on a first lens among the plurality of lenses and an incident light incident on at least part of a second lens among the plurality of lenses to a first pixel, and condense light of the second wavelength among an incident light incident on the second lens and an incident light incident on at least part of the first lens to a second pixel.

The image sensor may further include: a color filter layer disposed between the sensor substrate and the nano-photonic lens array; and a planarization layer disposed between the color filter layer and the nano-photonic lens array.

Each of the plurality of first pixels and the plurality of second pixels may include a plurality of photosensitive cells grouped in a first direction and a second direction perpendicular to the first direction, arranged two-dimensionally, and independently sensing the incident light, and the sensor substrate may include an isolation layer electrically isolating the plurality of photosensitive cells from one another.

The plurality of second holes may be arranged so as not to face the isolation layer.

According to an aspect of the disclosure, an electronic apparatus includes: a lens assembly configured to form an optical image of a subject; an image sensor configured to convert the optical image formed by the lens assembly into an electrical signal; and a processor configured to process the electrical signal generated by the image sensor, wherein the image sensor includes: a sensor substrate including a plurality of first pixels configured to sense light having a first wavelength and a plurality of second pixels configured to sense light having a second wavelength that is different from the first wavelength; a nano-photonic lens array having a light incident surface and including a plurality of nanostructures arranged to condense an incident light onto the plurality of first pixels and the plurality of second pixels; and an antireflection layer disposed on a light incident surface of the nano-photonic lens array and including a plurality of holes arranged periodically and two-dimensionally, wherein the plurality of holes include: a plurality of first holes provided at positions corresponding to boundary between first pixels, among the plurality of first pixels, and second pixels, among the plurality of second pixels, that are adjacent to each other; and a plurality of second holes facing an inner region of at least one of a first pixel among the plurality of first pixels or a second pixel among the plurality of second pixels.

According to an aspect of the disclosure, an image sensor includes: a sensor substrate including a first pixel configured to sense light of a first wavelength, a second pixel configured to sense light of a second wavelength different from the first wavelength, and an isolation layer dividing each of the first pixel and the second pixel into a plurality of photosensitive cells; a nano-photonic lens array having a light incident surface and including a plurality of nanostructures configured to condense an incident light onto the first pixel and the second pixel; and an antireflection layer disposed on the light incident surface of the nano-photonic lens array, wherein each of the first pixel and the second pixel includes an edge region and an inner region, and the antireflection layer includes a plurality of holes that face the inner region of each of the first pixel and the second pixel, and do not face the isolation layer.

The sensor substrate may further include a plurality of first pixels, including the first pixel, and a plurality of second pixels, including the second pixel, and the antireflection layer may further include a plurality of holes arranged at positions facing a boundary between a first pixel among the plurality of first pixels and a second pixel, among the plurality of second pixels, that adjacent to each other.

### BRIEF DESCRIPTION OF THE DRAWINGS

The above and other aspects, features, and advantages of certain example embodiments of the disclosure will be more apparent from the following description taken in conjunction with the accompanying drawings, in which:
FIG. 1 is a schematic block diagram of an image sensor according to an embodiment;
FIGS. 2A to 2C illustrate various pixel arrangements of a pixel array of an image sensor;
FIG. 3 is a perspective view schematically illustrating a configuration of a pixel array of an image sensor according to an embodiment;
FIG. 4 is a plan view schematically illustrating a configuration of a sensor substrate of the pixel array shown in FIG. 3;
FIG. 5 is a plan view schematically illustrating a configuration of a color filter layer shown in FIG. 3;
FIG. 6 is a plan view illustrating a configuration of a nano-photonic lens array shown in FIG. 3;
FIG. 7 illustrates phase profiles of green light and blue light passing through a nano-photonic lens array;
FIG. 8 illustrates propagation of a green light incident on a periphery of a first lens of a nano-photonic lens array;
FIG. 9 illustrates an array of a first green light condensing region formed by a nano-photonic lens array;
FIG. 10 illustrates propagation of a blue light incident on a periphery of a second lens of a nano-photonic lens array;
FIG. 11 illustrates an array of a blue light condensing region formed by a nano-photonic lens array;
FIG. 12 illustrates phase profiles of red light and green light passing through a nano-photonic lens array;
FIG. 13 illustrates propagation of a red light incident on a periphery of a third lens of a nano-photonic lens array;
FIG. 14 illustrates an array of a red light condensing region formed by a nano-photonic lens array;
FIG. 15 illustrates propagation of a green light incident on a periphery of a fourth lens of a nano-photonic lens array;
FIG. 16 illustrates an array of a second green light condensing region formed by a nano-photonic lens array;
FIG. 17 is a plan view illustrating a configuration of a nano-photonic lens array according to another example;
FIG. 18 is a plan view illustrating a configuration of a nano-photonic lens array according to another example;
FIG. 19 is a plan view illustrating a configuration of an antireflection layer shown in FIG. 3;
FIG. 20 is a cross-sectional view schematically illustrating a configuration of a pixel array of an image sensor according to an embodiment;
FIG. 21 is a graph illustrating a comparison between the reflectance of an image sensor according to an embodiment and the reflectance of an image sensor according to a comparative example;
FIG. 22 is a table illustrating a comparison between the average reflectance of an image sensor according to an embodiment and the average reflectance of image sensors according to comparative examples;
FIG. 23 is a cross-sectional view schematically illustrating a configuration of a pixel array of an image sensor according to another embodiment;
FIG. 24 is a cross-sectional view schematically illustrating a configuration of a pixel array of an image sensor according to another embodiment;
FIG. 25 is a cross-sectional view schematically illustrating a configuration of a pixel array of an image sensor according to another embodiment;
FIG. 26 is a plan view illustrating a configuration of an antireflection layer according to another embodiment;
FIG. 27 is a plan view illustrating a configuration of an antireflection layer according to another embodiment;
FIG. 28 is a block diagram schematically illustrating an electronic apparatus including an image sensor according to another embodiment; and
FIG. 29 is a block diagram schematically illustrating a camera module of FIG. 28.

### DETAILED DESCRIPTION

Reference will now be made in detail to example embodiments, which are illustrated in the accompanying drawings, wherein like reference numerals refer to like components throughout. In this regard, the present embodiments may have different forms and should not be construed as being limited to the descriptions set forth herein. Accordingly, the embodiments are described below, by referring to the figures, to explain aspects. As used herein, the term "and/or" includes any and all combinations of one or more of the associated listed items. Expressions such as "at least one of," when preceding a list of components, modify the entire list of components and do not modify the individual components of the list. For, example the expression "at least one of a, b or c" indicates only a, only b, only c, both a and b, both a and c, both b and c, or all of a, b, and c.

Hereinafter, an image sensor including a patterned antireflection layer and an electronic apparatus including the image sensor will be described in detail with reference to the accompanying drawings. The embodiments of the disclosure may be variously modified and may be embodied in many different forms. In the accompanying drawings, and the size of each component in the drawings may be exaggerated for clarity and convenience of description.

Hereinafter, what is described as "upper" or "on" may include those directly above, below, left, and right in contact, as well as above, below, left, and right in noncontact.

The terms such as "first" or "second" used herein may be used to describe various components, but may be used for the purpose of distinguishing one component from another component. These terms do not limit the difference in the material or structure of the components.

The singular forms are intended to include the plural forms as well, unless the context clearly indicates otherwise. When a part "comprises" or "includes" a component in the specification, unless otherwise defined, it is not excluding other components but may further include other components.

Also, in the specification, the term "unit" or "module" denote a unit or a module that processes at least one function or operation, and may be implemented by hardware, software, or a combination of hardware and software.

The term "above" and similar directional terms may be applied to both singular and plural.

Operations of a method described herein may be performed in any suitable order unless explicitly stated that they must be performed in the order described. In addition, the use of all exemplary terms (e.g., etc.) is merely for describing the technical idea in detail, and unless limited by the claims, the scope of rights is not limited by these terms.

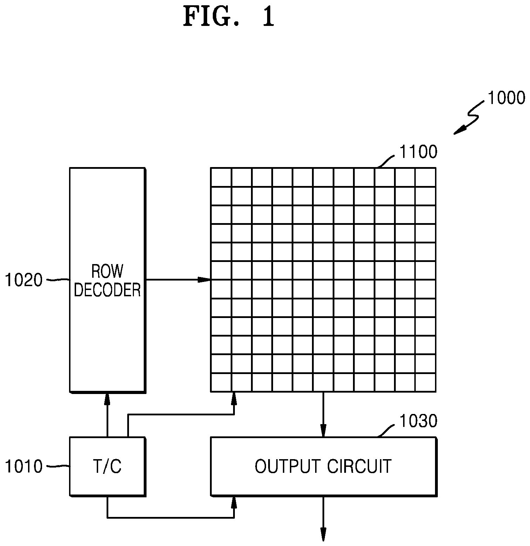

FIG. 1 is a schematic block diagram of an image sensor according to an embodiment. Referring to FIG. 1, an image sensor 1000 may include a pixel array 1100, a timing controller 1010, a row decoder 1020, and an output circuit 1030. The image sensor 1000 may be a charge coupled device (CCD) image sensor or a complementary metal oxide semiconductor (CMOS) image sensor.

The pixel array 1100 includes pixels that are two-dimensionally arranged along a plurality of rows and columns. The row decoder 1020 selects one of the rows of the pixel array 1100 in response to a row address signal output from the timing controller 1010. The output circuit 1030 outputs a photosensitive signal, in a column unit, from a plurality of pixels arranged along the selected row. To this end, the output circuit 1030 may include a column decoder and an analog-to-digital converter (ADC). For example, the output circuit 1030 may include the column decoder and a plurality of ADCs respectively disposed for each column between the column decoder and the pixel array 1100, or one ADC disposed at an output terminal of the column decoder. The timing controller 1010, the row decoder 1020, and the output circuit 1030 may be implemented as one chip or as separate chips. A processor processing an image signal output through the output circuit 1030 may be implemented as a single chip together with the timing controller 1010, the row decoder 1020, and the output circuit 1030.

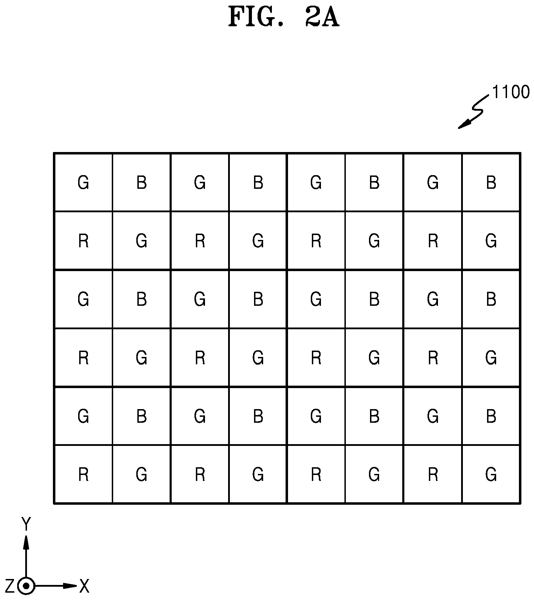

The pixel array 1100 may include a plurality of pixels sensing light of different wavelengths. The arrangement of pixels may be implemented in various ways. For example, FIGS. 2A to 2C illustrate various pixel arrangements of the pixel array 1100 of the image sensor 1000.

First, FIG. 2A illustrates a Bayer pattern generally adopted by the image sensor 1000. Referring to FIG. 2A, one unit pattern includes four quadrant regions, and first, second, third, and fourth quadrant regions may include a blue pixel B, a green pixel G, a red pixel R, and the green pixel G. These unit patterns are two-dimensionally repeatedly arranged along a first direction (X direction) and a second direction (Y direction). In other words, two green pixels G are arranged in one diagonal direction, and one blue pixel B and one red pixel R are arranged in the other diagonal direction, in a unit pattern of a 2×2 array. With regard to the overall pixel arrangement, a first row in which a plurality of green pixels G and a plurality of blue pixels B are alternately arranged in the first direction, and a second row in which a plurality of red pixels R and a plurality of green pixels G are alternately arranged in the first direction are repeatedly arranged in the second direction.

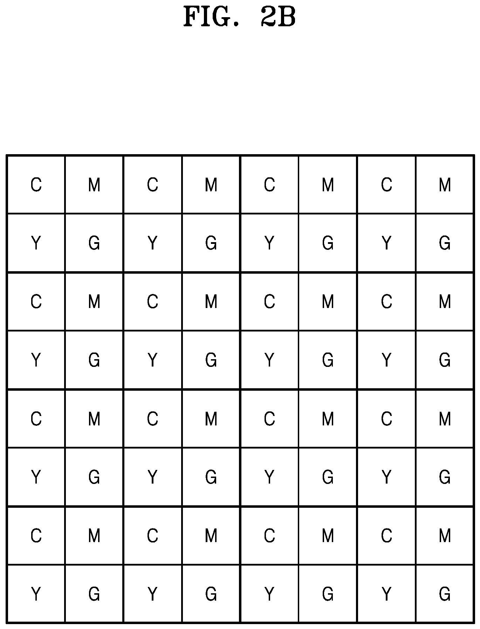

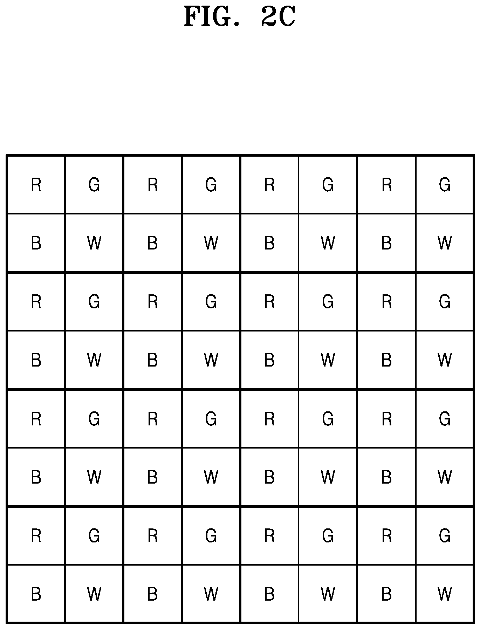

The pixel array 1100 may be arranged in various other ways, besides the Bayer pattern. For example, referring to FIG. 2B, the pixel array 1100 may be arranged in a CYGM pattern in which a magenta pixel M, a cyan pixel C, a yellow pixel Y, and a green pixel G constitute one unit pattern. Also, referring to FIG. 2C, the pixel array 1100 may also be arranged in a RGBW pattern in which a green pixel G, a red pixel R, a blue pixel B, and a white pixel W constitute one unit pattern. Also, the unit pattern may be in a 3×2 array. In addition, the pixels of the pixel array 1100 may be arranged in various ways according to color characteristics of the image sensor 1000. An example in which the pixel array 1100 of the image sensor 1000 has the Bayer pattern is described below, but the principle of operation may be applied to a pixel arrangement other than the Bayer pattern.

Hereinafter, for convenience, an example in which the pixel array 1100 has a Bayer pattern structure is described.

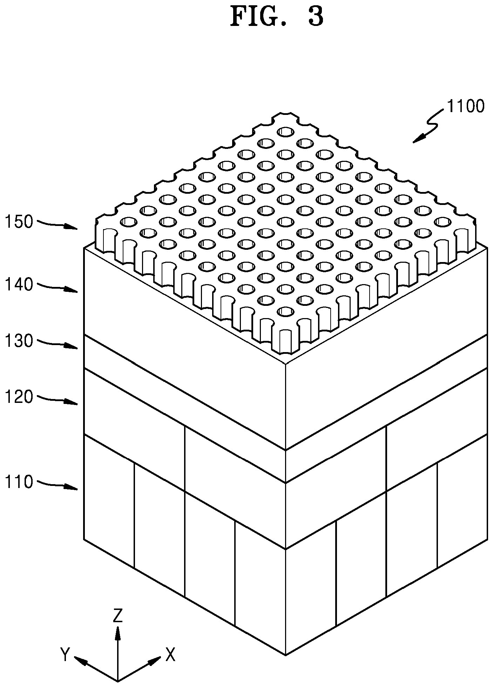

FIG. 3 is a perspective view schematically illustrating a configuration of a pixel array of an image sensor according to an embodiment. Referring to FIG. 3, the pixel array 1100 may include a sensor substrate 110, a color filter layer 120 disposed on the sensor substrate 110, a planarization layer 130 disposed on the color filter layer 120, a nano-photonic lens array 140 disposed on the planarization layer 130, and an antireflection layer 150 disposed on the nano-photonic lens array 140. The color filter layer 120 may be disposed between the sensor substrate 110 and the nano-photonic lens array 140, and the planarization layer 130 may be disposed between the color filter layer 120 and the nano-photonic lens array 140.

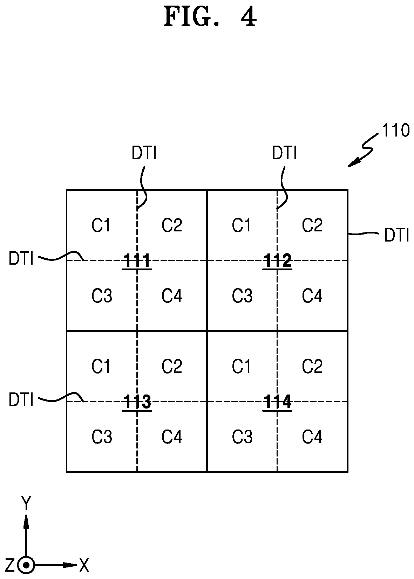

FIG. 4 is a plan view schematically illustrating a configuration of a sensor substrate of the pixel array 1100 shown in FIG. 3. Referring to FIG. 4, the sensor substrate 110 may include a plurality of pixels sensing an incident light. For example, the sensor substrate 110 may include a first pixel 111, a second pixel 112, a third pixel 113, and a fourth pixel 114 that convert the incident light into an electrical signal and generate an image signal. The first pixel 111, the second pixel 112, the third pixel 113, and the fourth pixel 114 may form one unit Bayer pattern. For example, the first pixel 111 and the fourth pixel 114 may be green pixels sensing green light, the second pixel 112 may be a blue pixel sensing blue light, and the third pixel 113 may be a red pixel sensing red light.

Although only one unit Bayer pattern including four pixels is illustrated in FIGS. 3 and 4, the pixel array 1100 may include a plurality of Bayer patterns that are two-dimensionally arranged. For example, the plurality of first pixels 111 and the plurality of second pixels 112 may be alternately arranged in the first direction (X direction), and the plurality of third pixels 113 and the plurality of fourth pixels 114 may be alternately arranged in a cross-section having a different position in the second direction (Y direction) perpendicular to the first direction (X direction).

Each of the first, second, third, and fourth pixels 111, 112, 113, and 114 may include a plurality of photosensitive cells independently sensing the incident light. For example, each of the first, second, third, and fourth pixels 111, 112, 113, and 114 may include first, second, third, and fourth photosensitive cells c1, c2, c3, and c4. The first, second, third, and fourth photosensitive cells c1, c2, c3, and c4 may be two-dimensionally arranged in the first direction (X direction) and the second direction (Y direction). For example, the first, second, third, and fourth photosensitive cells c1, c2, c3, and c4 may be arranged in a 2×2 array in each of the first, second, third, and fourth pixels 111, 112, 113, and 114.

FIG. 4 illustrates that each of the first, second, third, and fourth pixels 111, 112, 113, and 114 includes four photosensitive cells, but four or more independent photosensitive cells may be grouped and two-dimensionally arranged. For example, each of the first, second, third, and fourth pixels 111, 112, 113, and 114 may include a plurality of independent photosensitive cells arranged in a group in a 3×3 array or 4×4 array. Hereinafter, for convenience, a case in which each of the first, second, third, and fourth pixels 111, 112, 113, and 114 includes photosensitive cells arranged in a 2×2 array is described.

According to an embodiment, an autofocus signal may be obtained from a difference between output signals of adjacent photosensitive cells. For example, an autofocus signal in the first direction (X direction) may be generated from a difference between an output signal of the first photosensitive cell c1 and an output signal of the second photosensitive cell c2, a difference between an output signal of the third photosensitive cell c3 and an output signal of the fourth photosensitive cell c4, or a difference between the sum of the output signals of the first photosensitive cell c1 and the third photosensitive cell c3 and the sum of the output signals of the second photosensitive cell c2 and the fourth photosensitive cell c4. In addition, an autofocus signal in the second direction (Y direction) may be generated from a difference between the output signal of the first photosensitive cell c1 and the output signal of the third photosensitive cell c3, a difference between the output signal of the second photosensitive cell c2 and the output signal of the fourth photosensitive cell c4, or a difference between the sum of the output signals of the first photosensitive cell c1 and the second photosensitive cell c2 and the sum of the output signals of the third photosensitive cell c3 and the fourth photosensitive cell c4.

A general image signal may be obtained by summing the output signals of the first, second, third, and fourth photosensitive cells c1, c2, c3, and c4. For example, a first green image signal may be generated by summing the output signals of the first, second, third, and fourth photosensitive cells c1, c2, c3, and c4 of the first pixel 111, a blue image signal may be generated by summing the output signals of the first, second, third, and fourth photosensitive cells c1, c2, c3, and c4 of the second pixel 112, a red image signal may be generated by summing the output signals of the first, second, third, and fourth photosensitive cells c1, c2, c3, c4 of the third pixel 113, and a second green image signal may be generated by summing the output signals of the first, second, third, and fourth photosensitive cells c1, c2, c3, and c4 of the fourth pixel 114.

In addition, each of the first, second, third, and fourth pixels 111, 112, 113, and 114 may include an isolation layer DTI electrically separating the plurality of photosensitive cells. The isolation layer DTI may be formed, for example, in a deep trench isolation structure. A deep trench may be filled with air or an electrically insulating material. The isolation layer DTI may extend in the first direction (X direction) and the second direction (Y direction) so as to divide each of the first, second, third, and fourth pixels 111, 112, 113, and 114. The first, second, third, and fourth photosensitive cells c1, c2, c3 and c4 of each of the first, second, third, and fourth pixels 111, 112, 113, and 114 may be separated from each other by the isolation layer DTI. The isolation layer DTI extending in the first direction (X direction) and the isolation layer DTI extending in the second direction (Y direction) may cross each other at the center of each of the first, second, third, and fourth pixels 111, 112, 113 and 114.

Also, the isolation layers DTI may be disposed in the first direction (X direction) and the second direction (Y direction) between adjacent pixels among the first, second, third, and fourth pixels 111, 112, 113, and 114. Accordingly, the first, second, third, and fourth pixels 111, 112, 113, and 114 may be separated from each other by the isolation layer DTI. The isolation layer DTI extending in the first direction (X direction) and the isolation layer DTI extending in the second direction (Y direction) may cross each other at the center of the unit Bayer pattern including the first, second, third, and fourth pixels 111, 112, 113, and 114.

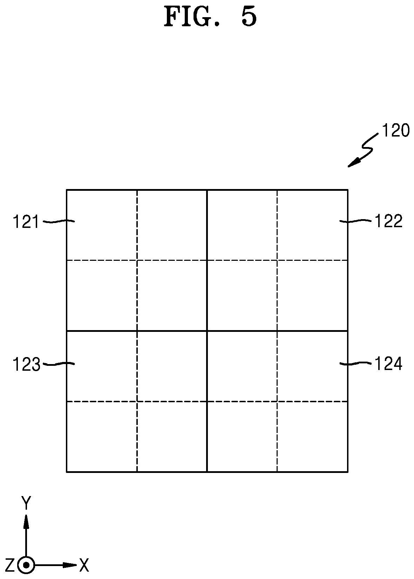

FIG. 5 is a plan view schematically illustrating a configuration of the color filter layer 120 shown in FIG. 3. Referring to FIG. 5, the color filter layer 120 may include a plurality of color filters that transmit light of a specific wavelength and absorb light of a different wavelength. For example, the color filter layer 120 may include a first color filter 121 that transmits light of a first wavelength and absorbs light of the other wavelengths, a second color filter 122 that transmits light of a second wavelength different from the first wavelength and absorbs light of the other wavelengths, a third color filter 123 that transmits light of a third wavelength different from the first and second wavelengths and absorbs light of the other wavelengths, and a fourth color filter 124 that transmits the light of the first wavelength and absorbs light of the other wavelengths. Although FIG. 5 illustrates only one unit Bayer pattern, a plurality of first color filters 121 and a plurality of second color filters 122 may be alternately arranged in the first direction (X direction), a plurality of third color filters 123 and a plurality of fourth color filters 124 may be alternately arranged in a cross-section having a different position in the second direction (Y direction) perpendicular to the first direction (X direction).

The first color filter 121 may be disposed so as to face the first pixel 111 in a third direction (Z direction), the second color filter 122 may be disposed so as to face the second pixel 112 in the third direction (Z direction), the third color filter 123 may be disposed so as to face the third pixel 113 in the third direction (Z direction), and the fourth color filter 124 may be disposed to face the fourth pixel 114 so as to face the third direction (Z direction). Accordingly, the first pixel 111 and the fourth pixel 114 may sense the light of the first wavelength that has transmitted through the first color filter 121 and the fourth color filter 124 respectively corresponding thereto. Also, the second pixel 112 may sense the light of the second wavelength that has transmitted through the second color filter 122 corresponding thereto. The third pixel 113 may sense the light of the third wavelength that has transmitted through the third color filter 123 corresponding thereto. For example, the first color filter 121 and the fourth color filter 124 may be green color filters that transmit green light, the second color filter 122 may be a blue color filter that transmits blue light, and the third color filter 123 may be a red color filter that transmits red light.

Dotted lines shown in FIG. 5 represent isolation layers between photosensitive cells of the first, second, third, and fourth pixels 111, 112, 113, and 114. As shown in FIG. 5, the first, second, third, and fourth color filters 121, 122, 123, and 124 may be disposed so as to face all photosensitive cells in the first, second, third, and fourth pixels 111, 112, 113 and 114 respectively corresponding thereto in the third direction (Z direction). In other words, the first color filter 121 may cover all the photosensitive cells in the first pixel 111, the second color filter 122 may cover all the photosensitive cells in the second pixel 112, the third color filter 123 may cover all the photosensitive cells in the third pixel 113, and the fourth color filter 124 may cover all the photosensitive cells in the fourth pixel 114.

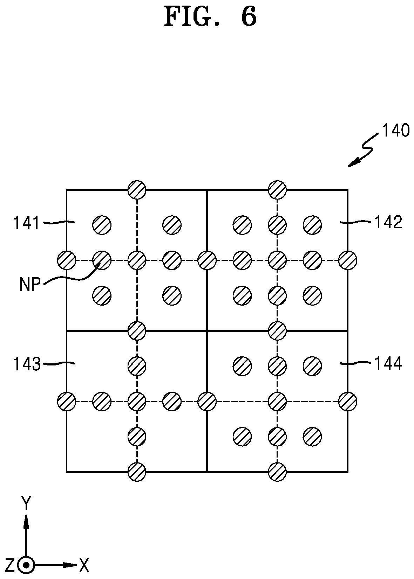

FIG. 6 is a plan view illustrating a configuration of a nano-photonic lens array shown in FIG. 3. Referring to FIG. 6, the nano-photonic lens array 140 may include a first lens 141 corresponding to the first pixel 111, a second lens 142 corresponding to the second pixel 112, a third lens 143 corresponding to the third pixel 113, and a fourth lens 144 corresponding to the fourth pixel 114. For example, the first lens 141 may be disposed so as to face the first pixel 111 in the third direction (Z direction), the second lens 142 may be disposed so as to face the second pixel 112 in the third direction (Z direction), the third lens 143 may be disposed so as to face the third pixel 113 in the third direction (Z direction), and the fourth lens 144 may be disposed so as to face the fourth pixel 114 in the third direction (Z direction). Although FIG. 6 illustrates only one unit Bayer pattern, a plurality of first lenses 141 and a plurality of second lenses 142 may be alternately arranged in the first direction (X direction), and a plurality of third lenses 143 and a plurality of fourth lenses 144 may be alternately arranged in a cross-section having a different position in the second direction (Y direction) perpendicular to the first direction (X direction).

The nano-photonic lens array 140 may include a plurality of nanostructures NP arranged so as to condense an incident light onto the first, second, third, and fourth pixels 111, 112, 113, and 114, respectively. The plurality of nanostructures NP may be arranged to differently change the phase of a transmitted light transmitting through the nano-photonic lens array 140 according to an incident position of the incident light on the nano-photonic lens array 140. A phase profile of the transmitted light implemented by the nano-photonic lens array 140 may be determined according to the width (or diameter) and the height of each nanostructure NP, and an arrangement period (or pitch) and an arrangement form of the plurality of nanostructures NP. Also, the behavior of the light transmitting through the nano-photonic lens array 140 may be determined according to the phase profile of the transmitted light. For example, the plurality of nanostructures NP may be arranged so as to form the phase profile through which light transmitted through the nano-photonic lens array 140 is condensed.

The size of the nanostructure NP may be smaller than the wavelength of a visible light. The size of the nanostructure NP may be smaller than, for example, a blue wavelength. For example, the width (or diameter) of a cross-section of the nanostructure NP may be less than about 400 nm, about 300 nm, or about 200 nm. The height of the nanostructure NP may be about 600 nm to about 2000 nm, and may be greater than the width of the cross-section. The nanostructure NP may have a structure of two or more layers stacked in the third direction (Z direction).

The nanostructure NP may include a material having a relatively high refractive index compared to peripheral materials and a relatively low absorption in a visible light band. For example, the nanostructure NP may include c-Si, p-Si, a-Si and a Group III-V compound semiconductor (GaP, GaN, GaAs etc.), SiC, TiO₂, SiN₃, ZnS, ZnSe, Si₃N₄, and/or a combination thereof. A periphery of the nanostructure NP may be filled with a dielectric material having a relatively low refractive index compared to the nanostructure NP and a relatively low absorption in the visible light band. For example, the periphery of the nanostructure NP may be filled with siloxane-based spin on glass (SOG), SiO₂, Si₃N₄, Al₂O₃, air, etc.

The refractive index of the nanostructure NP may be equal to or greater than about 2.0 with respect to light having a wavelength of about 630 nm, and the refractive index of a peripheral material may be equal to or greater than about 1.0 and less than about 2.0 with respect to the light having the wavelength of about 630 nm. In addition, the difference between the refractive index of the nanostructure NP and the refractive index of the peripheral material may be about 0.5 or more. The nanostructure NP different from that of the peripheral material in the refractive index may change the phase of light passing through the nanostructure NP. This is due to a phase delay caused by the shape dimension of a sub-wavelength of the nanostructures NP, and a degree of the phase delay is determined by a detailed shape dimension and an arrangement form of the nanostructures NP.

In an example, the nano-photonic lens array 140 may condense light of a first wavelength of the incident light onto the first pixel 111 and the fourth pixel 114, may condense light of a second wavelength onto the second pixel 112, and may condense light of a third wavelength onto the third pixel 113. Then, the incident light may be separated by the nano-photonic lens array 140 according to wavelengths and condensed onto the first, second, third, and fourth pixels 111, 112, 113, and 114. To this end, the plurality of nanostructures NP may be arranged in different forms in the first, second, third, and fourth lenses 141, 142, 143, and 144 of the nano-photonic lens array 140. Although FIG. 6 illustrates that the nanostructures NP all have the same diameter, this is only an example and the nanostructures NP may have different diameters. In addition, the nanostructures NP may also have various arrangement forms. In an embodiment, as long as the incident light is sufficiently color-separated by the nano-photonic lens array 140, the color filter layer 120 may be omitted.

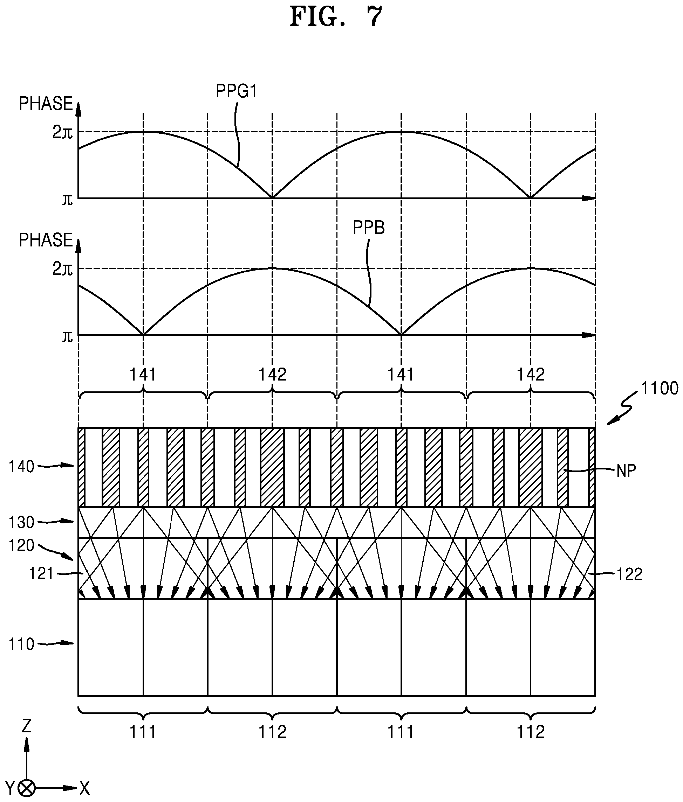

FIG. 7 illustrates phase profiles of green light and blue light passing through the nano-photonic lens array 140. Referring to FIG. 7, green light passing through the nano-photonic lens array 140 may have a first green light phase profile PPG1 that is the greatest at the center of the first lens 141, and decreases in a direction away from the center of the first lens 141. Specifically, at a position immediately after passing through the nano-photonic lens array 140, that is, on a lower surface of the nano-photonic lens array 140 or an upper surface of the planarization layer 130, the phase of the green light may be the greatest at the center of the first lens 141, and may gradually decrease in the form of concentric circles away from the center of the first lens 141. When the phase of the green light emitted from the center of the first lens 141 is set as 2π, light having a phase of about 0.9π to about 1.1π may be emitted from the center of each of the second lens 142 and the third lens 143, light having a phase of about 2π may be emitted from the center of the fourth lens 144, and light having a phase of about 1.1π to about 1.5π may be emitted from a contact point between the first lens 141 and the fourth lens 144. Accordingly, a phase difference between the green light passing through the center of the first lens 141 and the green light passing through the center of each of the second lens 142 and the third lens 143 may be about 0.9π to about 1.1π.

On the other hand, the first green light phase profile PPG1 does not mean that the phase delay amount of light passing through the center of the first lens 141 is the largest. When the phase of the light passing through the first lens 141 is set as 2π and the phase delay amount of the light passing through another position is larger and has a phase value greater than 2π, the phase profile of another position may have a value remaining after subtracting 2nπ, that is, a wrapped phase. For example, when the phase of light passing through the first lens 141 is 2π and the phase of light passing through the center of the second lens 142 is 3π, the phase of light in the second lens 142 may be π remaining after subtracting 2π (when n=1) from 3π.

In addition, the blue light passing through the nano-photonic lens array 140 may have a blue light phase profile PPB that is the greatest at the center of the second lens 142 and decreases in a direction away from the center of the second lens 142. Specifically, the phase of the blue light at the position immediately after passing through the nano-photonic lens array 140 may be the greatest at the center of the second lens 142, and may gradually decrease in the form of concentric circles away from the center of the second lens 142. For example, when the phase of the blue light at the center of the second lens 142 is 2π, the phase at the center of each of the first lens 141 and the fourth lens 144 may be about 0.9π to about 1.1π, and the phase of the blue light at the center of the fourth lens 143 may be a value of, for example, about 0.5π to about 0.9π less than the phase of the blue light at the center of each of the first lens 141 and the fourth lens 144.

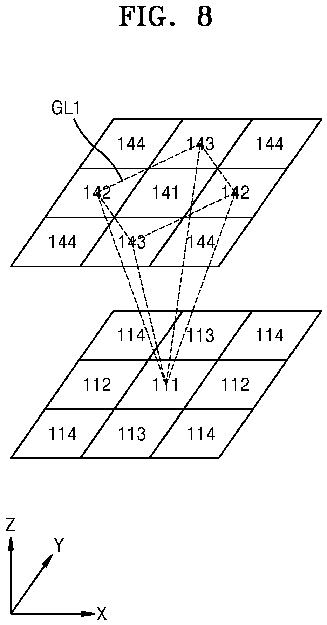

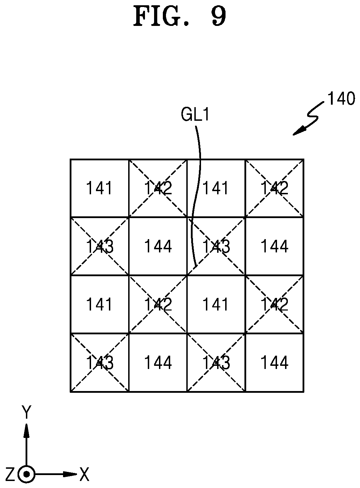

FIG. 8 illustrates propagation of a green light incident on a periphery of a first lens of a nano-photonic lens array, and FIG. 9 illustrates an array of a first green light condensing region formed by the nano-photonic lens array.

Referring to FIG. 8, the green light of an incident light incident on the first lens 141 and an incident light incident on a part of the second lens 142 and a part of the third lens 143 of a periphery of the first lens 141 may be condensed onto the first pixel 111 by the nano-photonic lens array 140. That is, the phase profile of the green light described with reference to FIG. 7 may condense, onto the first pixel 111, the green light passing through a first green light condensing region GL1 connecting centers of two second lenses142 and two third lenses 143 having one side facing and adjacent to the first lens 141. Accordingly, as shown in FIG. 9, the nano-photonic lens array 140 may operate as an array of the first green light condensing region GL1 condensing the green light onto the first pixel 111. The area of the first green light condensing region GL1 may be larger than that of the corresponding first pixel 111, for example, about 1.2 times to about 2 times.

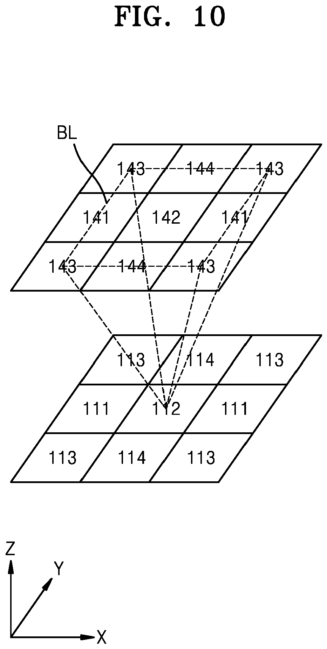

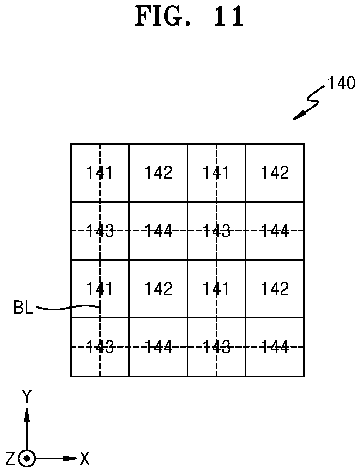

FIG. 10 illustrates propagation of a blue light incident on a periphery of a second lens of a nano-photonic lens array, and FIG. 11 illustrates an array of a blue light condensing region formed by a nano-photonic lens array.

Referring to FIG. 10, the blue light of an incident light incident on the second lens 142 and an incident light incident on a part of the first lens 141, a part of the third lens 143, and a part of the fourth lens 144 of a periphery of the second lens 142 may be condensed onto the second pixel 112 by the nano-photonic lens array 140. That is, the phase profile of the blue light described with reference to FIG. 7 may condense, onto the second pixel 112, the blue light passing through a blue light condensing region BL formed by connecting centers of four third lenses 143 having vertices facing and adjacent to the second lens 142. Accordingly, as shown in FIG. 11, the nano-photonic lens array 140 may operate as an array of the blue light condensing region BL condensing the blue light onto the second pixel 112. The area of the blue light condensing region BL may be larger than that of the corresponding second pixel 112, for example, about 1.5 times to about 4 times. A part of the blue light condensing region BL may overlap a part of the first green light condensing region GL1, a part of a second green light condensing region GL2 to be described below, and a part of a red light condensing region RL to be described below.

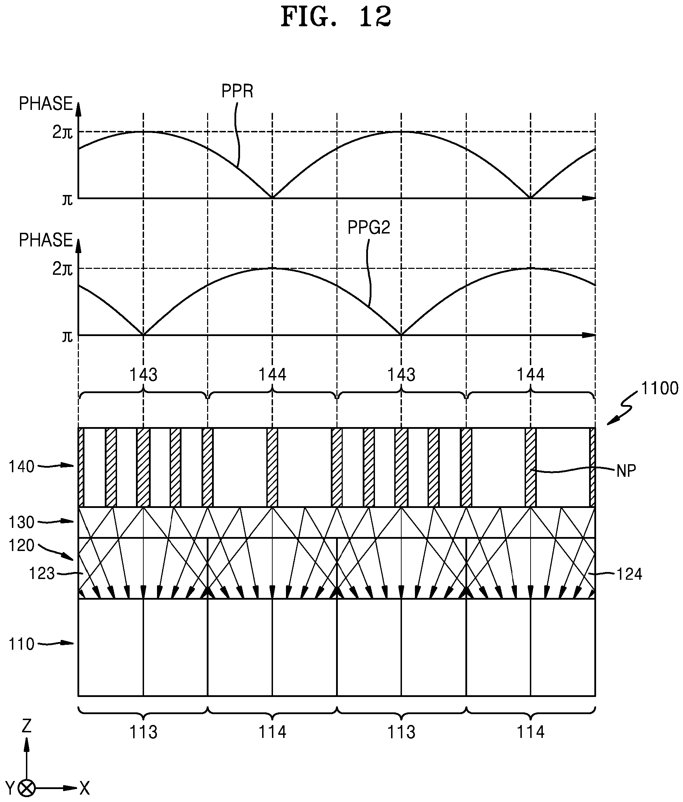

FIG. 12 illustrates phase profiles of red light and green light passing through a nano-photonic lens array. Referring to FIG. 12, the red light passing through the nano-photonic lens array 140 may have a red light phase profile PPR that is the greatest at the center of the third lens 143, and decreases in a direction away from the center of the third lens 143. Specifically, the phase of the red light at a position immediately after passing through the nano-photonic lens array 140 may be the greatest at the center of the third lens 143, and may gradually decrease in the form of concentric circles away from the center of the third lens 143. When the phase of the red light at the center of the third lens 143 is 2π, the phase at the center of each of the first lens 141 and the fourth lens 144 may be, for example, about 0.9π to about 1.1π, and the phase of the red light at the center of the second lens 142 may be a value, for example, about 0.5π to about 0.9π, less than the phase at the center of each of the first lens 141 and the fourth lens 144.

In addition, the green light passing through the nano-photonic lens array 140 may have a second green light phase profile PPG2 that is the greatest at the center of the fourth lens 144 and decreases in a direction away from the center of the fourth lens 144. Except for the fact that the second green light phase profile PPG2 has the largest phase at the center of the fourth lens 144, the description of the first green light phase profile PPG1 may be equally applied to the second green light phase profile PPG2.

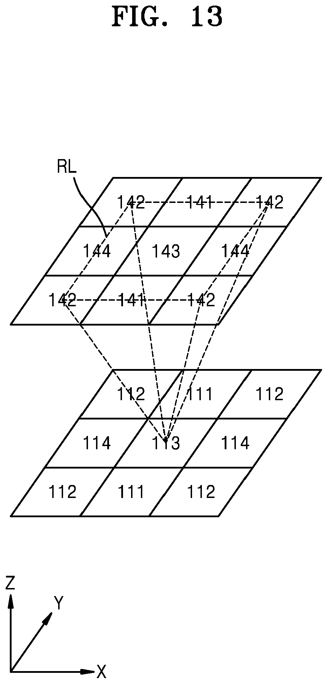

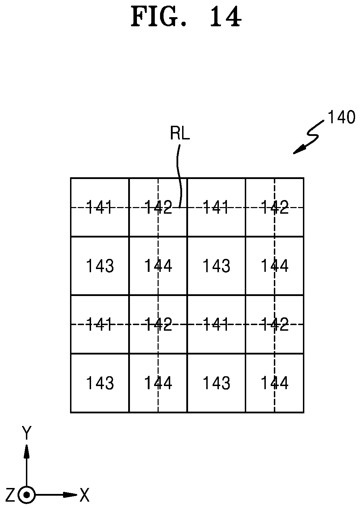

FIG. 13 illustrates propagation of a red light incident on a periphery of a third lens of a nano-photonic lens array, and FIG. 14 illustrates an array of a red light condensing region formed by a nano-photonic lens array.

Referring to FIG. 13, the red light of an incident light incident on the third lens 143 and an incident light incident on a part of the first lens 141, a part of the second lens 142, and a part of the fourth lens 144 of a periphery of the third lens 143 may be condensed onto the third pixel 113 by the nano-photonic lens array 140. That is, the phase profile of the red light described with reference to FIG. 12 may condense, onto the third pixel 113, the red light passing through a red light condensing region RL formed by connecting centers of four second lenses 142 having vertices facing and adjacent to the third lens 143. Accordingly, as shown in FIG. 14, the nano-photonic lens array 140 may operate as an array of the red light condensing region RL condensing the red light onto the third pixel 113. The area of the red light condensing region RL may be larger than that of the corresponding third pixel 113, for example, about 1.5 times to about 4 times. A part of the red light condensing region RL may overlap a part of the first green light condensing region GL1, a part of the blue light condensing region BL, and a part of a second green light condensing region GL2 to be described below.

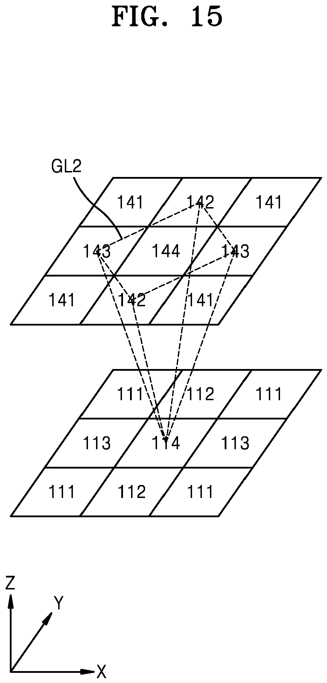

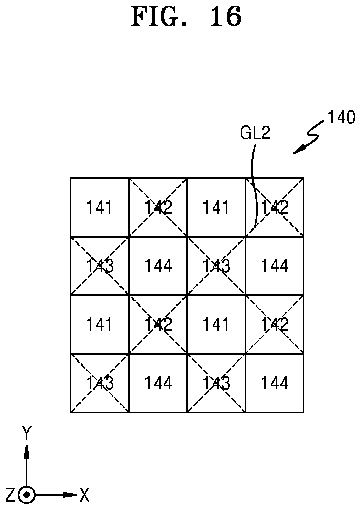

FIG. 15 illustrates propagation of a green light incident on a periphery of a fourth lens of a nano-photonic lens array, and FIG. 16 illustrates an array of a second green light condensing region formed by a nano-photonic lens array.

Referring to FIG. 15, the green light of an incident light incident on the fourth lens 144 and an incident light incident on a part of the second lens 142 and a part of the third lens 143 of a periphery of the fourth lens 144 may be condensed onto the fourth pixel 114 by the nano-photonic lens array 140. That is, the phase profile of the green light described with reference to FIG. 12 may condense, onto the fourth pixel 114, the green light passing through a second green light condensing region GL2 connecting centers of two second lenses142 and two third lenses 143 having one side facing and adjacent to the fourth lens 144. Accordingly, as shown in FIG. 16, the nano-photonic lens array 140 may operate as an array of the second green light condensing region GL2 condensing the green light onto the fourth pixel 114. The second green light condensing region GL2 may be larger than that of the corresponding fourth pixel 114, for example, about 1.2 times to about 2 times. A part of the second green light condensing region GL2 may overlap a part of the first green light condensing region GL1, a part of the blue light condensing region BL, and a part of the red light condensing region RL.

It has been described with reference to FIGS. 7 to 16 that the first, second, third, and fourth lenses 141, 142, 143, and 144 of the nano-photonic lens array 140 respectively serve as one lens with respect to the first, second, third, and fourth pixels 111, 112, 113 and 114. In other words, the first, second, third, and fourth lenses 141, 142, 143, and 144 may operate as one lens with respect to all of the first, second, third, and fourth photosensitive cells c1, c2, c3, and c4 of the first, second, third, and fourth pixels 111, 112, 113 and 114 respectively corresponding thereto. In this case, a focus may be formed at a desired position of each of the first, second, third, and fourth pixels 111, 112, 113, and 114.

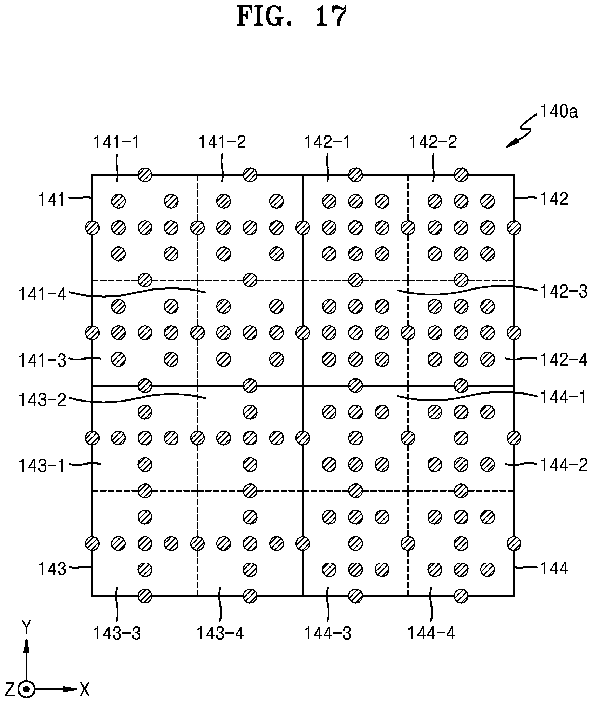

FIG. 17 is a plan view illustrating a configuration of a nano-photonic lens array according to another embodiment. Referring to FIG. 17, the first lens 141 of a nano-photonic lens array 140a may include sub-lenses 141-1, 141-2, 141-3, and 141-4 respectively corresponding to the first, second, third, and fourth photosensitive cells c1, c2, c3 and c4 of the first pixel 111. In addition, the second lens 142 may include sub-lenses 142-1, 142-2, 142-3, and 142-4 respectively corresponding to the first, second, third, and fourth photosensitive cells c1, c2, c3, and c4 of the second pixel 112, the third lens 143 may include sub-lenses 143-1, 143-2, 143-3, and 143-4 respectively corresponding to the first, second, third, and fourth photosensitive cells c1, c2, c3, and c4 of the third pixel 113, and the fourth lens 144 may include sub-lenses 144-1, 144-2, 144-3, and 144-4 respectively corresponding to the first, second, third, and fourth photosensitive cells c1, c2, c3, and c4 of the fourth pixel 114. The nano-photonic lens array 140a shown in FIG. 17 may operate so as to provide a function of one lens with respect to each of the first, second, third, and fourth photosensitive cells c1, c2, c3, and c4 of the first, second, third, and fourth pixels 111, 112, 113, and 114. In this case, a focus may be formed on each of the first, second, third, and fourth photosensitive cells c1, c2, c3 and c4 of the first, second, third, and fourth pixels 111, 112, 113, and 114.

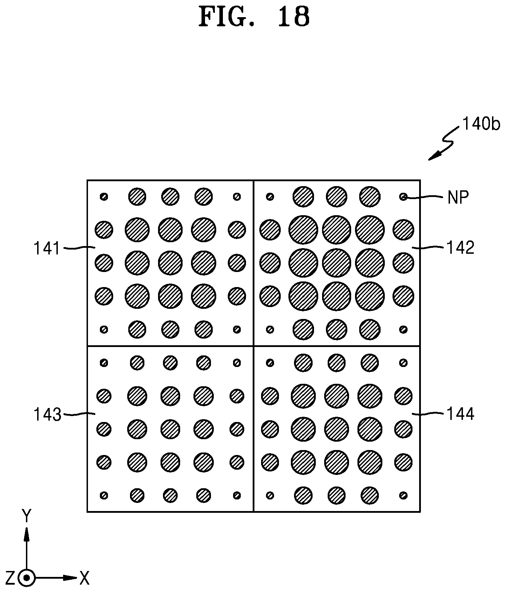

FIG. 18 is a plan view illustrating a configuration of a nano-photonic lens array according to another embodiment. Referring to FIG. 18, a nano-photonic lens array 140b may include first, second, third, and fourth lenses 141, 142, 143, and 144 that simply condense an incident light onto the first, second, third, and fourth pixels 111, 112, 113 and 114 respectively without a color separation. For example, the first, second, third, and fourth lenses 141, 142, 143, and 144 simply condense the incident light onto the first, second, third, and fourth pixels 111, 112, 113 and 114 respectively corresponding thereto, and the color separation may be performed by the color filter layer 120. To this end, the plurality of nanostructures NP may be arranged in a symmetrical shape in the first direction (X direction) and the second direction (Y direction) in each of the first, second, third, and fourth lenses 141, 142, 143 and 144 with respect to the center of each of the first, second, third, and fourth lenses 141, 142, 143 and 144. In particular, the nanostructures NP arranged in a central region of each of the first, second, third, and fourth lenses 141, 142, 143, and 144 may have the largest diameter so that the largest phase delay occurs in the central region of each of the first, second, third, and fourth lenses 141, 142, 143, and 144, and the diameter of the nanostructure NP may gradually decrease away from the central region of each of the first, second, third, and fourth lenses 141, 142, 143, and 144.

In the nano-photonic lens array 140b shown in FIG. 18, the first, second, third, and fourth lenses 141, 142, 143 and 144 may operate as one lens with respect to all of the first, second, third, and fourth photosensitive cells c1, c2, c3, and c4 of the first, second, third, and fourth pixels 111, 112, 113 and 114 respectively corresponding thereto. In another embodiment, the nano-photonic lens array 140b may be configured so as to form a focus on each of the first, second, third, and fourth photosensitive cells c1, c2, c3, and c4 of the first, second, third, and fourth pixels 111, 112, 113, and 114.

In an embodiment, the planarization layer 130 may provide a flat surface so as to form the nano-photonic lens array 140 on the color filter layer 120. In addition, the planarization layer 130 may serve as a spacer providing a distance between the sensor substrate 110 and the nano-photonic lens array 140 together with the color filter layer 120. The distance between the sensor substrate 110 and the nano-photonic lens array 140 may be determined by a focal length of the nano-photonic lens array 140. For example, the thickness of the planarization layer 130 and the thickness of the color filter layer 120 may be the same as the focal length of the nano-photonic lens array 140. Then, the light condensed by the nano-photonic lens array 140 may be focused on the sensor substrate 110. When the focal length of the nano-photonic lens array 140 is sufficiently short, the planarization layer 130 may be omitted.

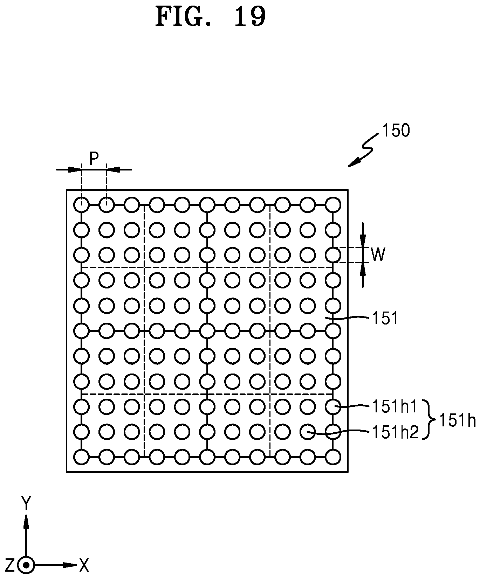

FIG. 19 is a plan view illustrating a configuration of an antireflection layer shown in FIG. 3. Referring to FIG. 19, the antireflection layer 150 may have a patterned structure to include a plurality of holes that are periodically two-dimensionally arranged. For example, the antireflection layer 150 may include a dielectric layer 151 transparent to a visible light and a plurality of holes 151h penetrating the dielectric layer 151 in the third direction (Z direction). The dielectric layer 151 may include, for example, at least one of AlO, HfO, SiN, SiO₂, AlOC, AlON, and AlOCN, or a combination thereof. Alternatively, in addition to the above-described materials, the dielectric layer 151 may include other inorganic materials having a refractive index equal to or greater than about 1 and equal to or less than about 3. The plurality of holes 151h may each have a smaller dimension than that of a wavelength of the visible light, particularly, a wavelength of a blue light. For example, an arrangement period P of the plurality of holes 151h may be equal to or less than about 300 nm. Also, a width W or a diameter of each of the plurality of holes 151h may be equal to or less than about 300 nm. In an example, the arrangement period P of the plurality of holes 151h may be the same in the entire region of the antireflection layer 150, the width W or diameter of each of the plurality of holes 151h may also be the same in the entire region of the antireflection layer 150, and the shape of each of the plurality of holes 151h may be the same in the entire region of the antireflection layer 150.

The antireflection layer 150 serves to reduce a light loss caused by an incident light being reflected by the nano-photonic lens array 140 therebelow. To this end, an average refractive index of the antireflection layer 150 may be greater than a refractive index of air and less than an average refractive index of the nano-photonic lens array 140. For example, when a refractive index section between the refractive index of air and the average refractive index of the nano-photonic lens array 140 is divided into three equal parts, the average refractive index of the antireflection layer 150 may be in a middle third section of the refractive index section. The average refractive index of the antireflection layer 150 may be determined by the refractive index and volume of the dielectric layer 151 and the refractive index and volume of air filled in the plurality of holes 151h. The average refractive index of the nano-photonic lens array 140 may be determined by the refractive index and volume of the nanostructure NP and the refractive index and volume of a peripheral material. The arrangement period P of the plurality of holes 151h and the width W or diameter of each of the plurality of holes 151h may be determined such that the average refractive index of the antireflection layer 150 satisfies the above-described condition.

In addition, in consideration of the nano-photonic lens array 140 having the patterned structure, positions of the holes 151h of the antireflection layer 150 may be selected so as to further reduce a reflection loss. For example, the arrangement period P of the plurality of holes 151h and the width W or diameter of each of the plurality of holes 151h may be determined such that the holes 151h are positioned on a boundary between two adjacent pixels. According to an embodiment, the plurality of holes 151h may include a plurality of first holes 151h1 arranged in a region of the antireflection layer 150 facing the boundary between the two adjacent pixels and a plurality of second holes 151h2 arranged in a region of the antireflection layer 150 facing an inner region of each of the pixels. For example, the plurality of first holes 151h1 may be arranged in the first direction (X direction) and the second direction (Y direction) along a boundary between the first pixel 111 and the second pixel 112, a boundary between the first pixel 111 and the third pixel 113, a boundary between the second pixel 112 and the fourth pixel 114, and a boundary between the third pixel 113 and the fourth pixel 114. In particular, the center of each of the plurality of first holes 151h1 may be located above a boundary between two adjacent pixels. In other words, the center of each of the plurality of first holes 151h1 may face a boundary between two adjacent pixels in the third direction (Z direction).

The plurality of first holes 151h1 and the plurality of second holes 151h2 may respectively have the same shape and size. Also, the plurality of first holes 151h1 and the plurality of second holes 151h2 may be arranged in the same period. For example, an interval between two adjacent first holes 151h1, an interval between two adjacent second holes 151h2, and an interval between the first and second holes 151h1 and 151h2 may all be the same.

Dotted lines shown in FIG. 19 represent isolation layers between the photosensitive cells of the first, second, third, and fourth pixels 111, 112, 113, and 114. In an example, the plurality of second holes 151h2 arranged in the region of the antireflection layer 150 facing the inner region of each of the first, second, third, and fourth pixels 111, 112, 113 and 114 may not face the isolation layers between the photosensitive cells. In other words, the plurality of second holes 151h2 disposed to face the inner region of each of the first, second, third, and fourth pixels 111, 112, 113, and 114 may be arranged in the first direction (X direction) and the second direction (Y direction) so as not to face the isolation layers between the photosensitive cells in the third direction (Z direction). In this case, any hole 151h may be not be positioned in an upper portion of the isolation layers between the photosensitive cells of each of the first, second, third, and fourth pixels 111, 112, 113, and 114.

However, the disclosure is not necessarily limited thereto. In another example, some of the plurality of second holes 151h2 may be disposed to face the isolation layers between the photosensitive cells in the third direction (Z direction) according to the arrangement period P of the plurality of holes 151h and the width W or diameter of each of the plurality of holes 151h.

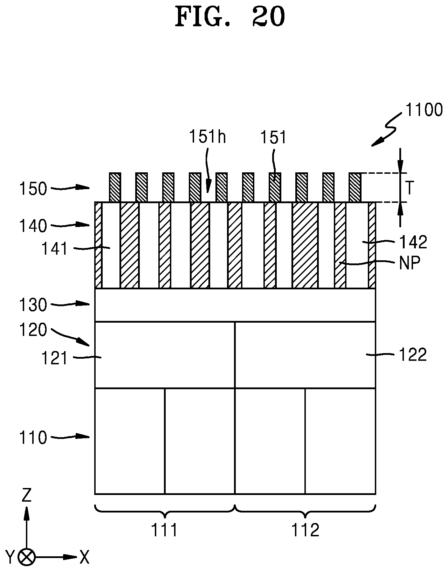

FIG. 20 is a cross-sectional view schematically illustrating a configuration of a pixel array of an image sensor according to an embodiment. In particular, FIG. 20 is a cross-sectional view of the pixel array 1100 in which the first pixel 111 and the second pixel 112 are cut in the first direction (X direction). Referring to FIG. 20, the antireflection layer 150 may be disposed on a light incident surface of the nano-photonic lens array 140. Accordingly, an incident light traveling toward the pixel array 1100 may be first incident on the antireflection layer 150, and then reach the sensor substrate 110 through the antireflection layer 150, the nano-photonic lens array 140, the planarization layer 130, and the color filter layer 120. In order to reduce a light loss due to the antireflection layer 150, a thickness T of the antireflection layer 150 may be less than the thickness of the nano-photonic lens array 140. In particular, when the thickness of the nano-photonic lens array 140 is about 600 nm to about 2000 nm, the thickness T of the antireflection layer 150 may be 20 % of the thickness of the nano-photonic lens array 140 or less. For example, the thickness T of the antireflection layer 150 may be equal to or greater than about 50 nm and equal to or less than about 400 nm.

As shown in FIG. 20, the hole 151h of the antireflection layer 150 may be formed to penetrate the dielectric layer 151. The inside of the hole 151h may be filled with air. Accordingly, an upper surface of the nano-photonic lens array 140 may be exposed through the hole 151h. Also, the refractive index of the hole 151h may be lower than that of the dielectric layer 151 surrounding the hole 151h. The hole 151h having a relatively low refractive index is positioned on the boundary between the first pixel 111 and the second pixel 112. Accordingly, an average refractive index of a part of the antireflection layer 150 facing the boundary between pixels in the third direction (Z direction) may be slightly lower than an average refractive index of other parts of the antireflection layer 150.

The width or diameter of the hole 151h may be continuously changed in the third direction (Z direction) according to an etching process of forming the hole 151h. For example, the width or diameter of the hole 151h on a lower surface of the antireflection layer 150 may be less than the width or diameter of the hole 151h on the upper surface of the antireflection layer 150. Alternatively, the cross-sectional width of the dielectric layer 151 may gradually increase from up to down. In this case, the width or diameter of the hole 151h may be defined as the width or diameter of the hole 151h on the upper surface of the antireflection layer 150.

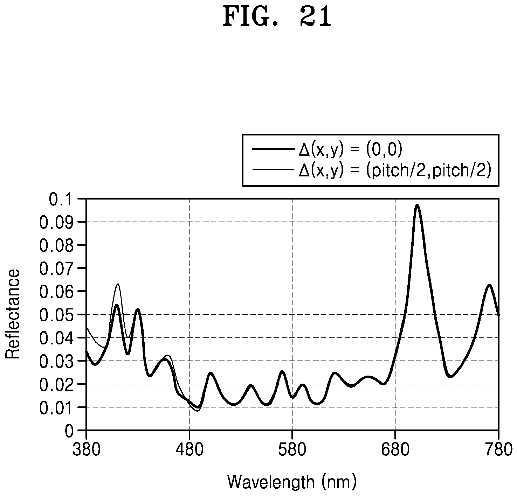

FIG. 21 is a graph illustrating a comparison between the reflectance of an image sensor according to an embodiment and the reflectance of an image sensor according to a comparative example. In FIG. 21, the horizontal axis indicates wavelength and the vertical axis indicates reflectance. In addition, a thin solid line indicates the reflectance of the image sensor according to the comparative example, and a thick solid line indicates the reflectance of the image sensor according to the embodiment. In the comparative example, positions of the plurality of holes 151h in the antireflection layer 150 are shifted by 1/2 pitch, that is, 1/2 of the arrangement period of the plurality of holes 151h, in the first direction (X direction) and the second direction (Y direction) compared to the embodiment, and the hole 151h is not positioned on a boundary of pixels. Referring to the graph of FIG. 21, it may be seen that the reflectance of the image sensor according to the embodiment is lowered in a blue wavelength band.

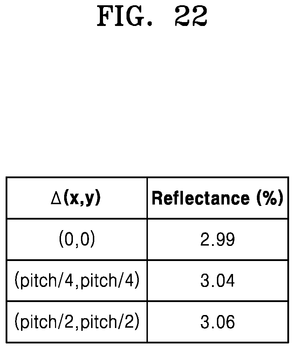

Also, FIG. 22 is a table illustrating a comparison between the average reflectance of an image sensor according to an embodiment and the average reflectance of image sensors according to comparative examples. In the table of FIG. 22, (0, 0) indicates the embodiment in which positions of the holes 151h are not shifted, (pitch/4, pitch/4) indicates the comparative example in which the positions of the plurality of holes 151h are shifted by 1/4 pitch compared to the embodiment, and (pitch/2, pitch/2) indicates the comparative example in which the positions of the plurality of holes 151h are shifted by 1/2 pitch compared to the embodiment. Referring to the table of FIG. 22, it may be seen that the overall reflectance of the image sensor is slightly lowered in the embodiment compared to the comparative examples in which the hole 151h is not positioned on the boundary of the pixels.

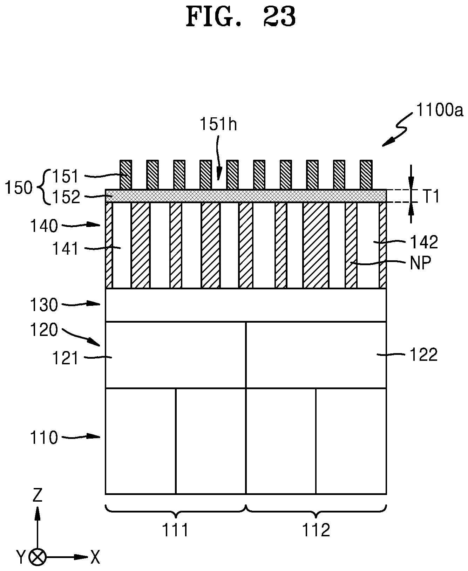

FIG. 23 is a cross-sectional view schematically illustrating a configuration of a pixel array of an image sensor according to another embodiment. Referring to FIG. 23, the antireflection layer 150 of the pixel array 1100a may further include an etch stop layer 152 disposed between the dielectric layer 151 and the nano-photonic lens array 140. The etch stop layer 152 may be regarded as a part of the antireflection layer 150, and in this case, the antireflection layer 150 may have a two-layer structure. For example, the etch stop layer 152 may be considered as a first antireflection layer disposed on a light incident surface of the nano-photonic lens array 140, and the dielectric layer 151 and the plurality of holes 151h may be considered as a second antireflection layer disposed on the first antireflection layer.

The etch stop layer 152 that is the first antireflection layer may not be patterned, and only the second antireflection layer may be patterned to include the plurality of holes 151h. Accordingly, the etch stop layer 152 may have an unpatterned flat top surface. The etch stop layer 152 that is the first antireflection layer may serve to protect the nano-photonic lens array 140 from being etched in a process of forming the plurality of holes 151h. To this end, the refractive index of the etch stop layer 152 may be higher than that of the dielectric layer 151 of the second antireflection layer. For example, the etch stop layer 152 may include at least one of AlO, SiN, or HfO, and the dielectric layer 151 of the second antireflection layer may include a material having a refractive index lower than that of AlO, SiN, or HfO, for example, SiO₂ or AlON. Also, the thickness T1 of the etch stop layer 152 may be less than the thickness of the second antireflection layer so that the reflectance of the image sensor is not increased by the etch stop layer 152. For example, the thickness T1 of the etch stop layer 152 may be equal to or greater than about 5 nm and equal to or less than about 50 nm. The total thickness of the antireflection layer 150 including the etch stop layer 152 and the dielectric layer 151 may be equal to or greater than about 50 nm and equal to or less than about 400 nm.

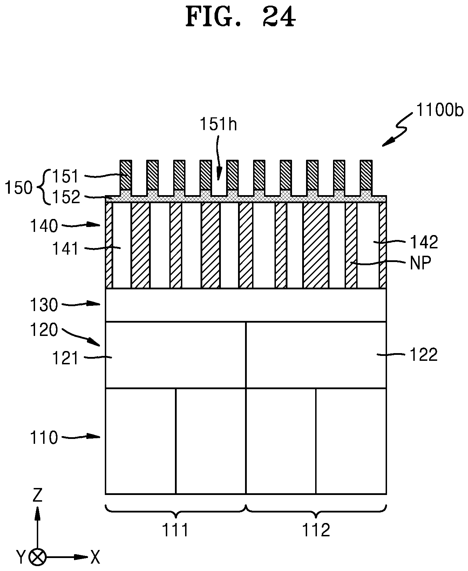

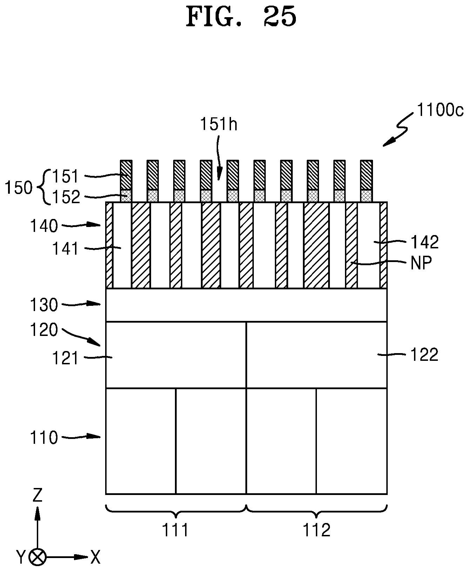

FIGS. 24 and 25 are cross-sectional views schematically illustrating configurations of pixel arrays of an image sensor according to alternative embodiments. Referring to FIG. 24, the antireflection layer 150 of a pixel array 1100b may include the partially patterned etch stop layer 152. For example, an upper surface of the etch stop layer 152 that is a first antireflection layer may be patterned to have a plurality of non-through holes respectively connected to the plurality of holes 151h of the second antireflection layer disposed thereon. Also, referring to FIG. 25, the antireflection layer 150 of a pixel array 1100c may include the etch stop layer 152 patterned to have a through hole. In this case, it may be seen that the plurality of holes 151h are formed to penetrate both the etch stop layer 152 that is the first antireflection layer and a second antireflection layer disposed thereon. As shown in FIGS. 24 and 25, the etch stop layer 152 that is the first antireflection layer may be at least partially patterned to include the plurality of holes 151h.

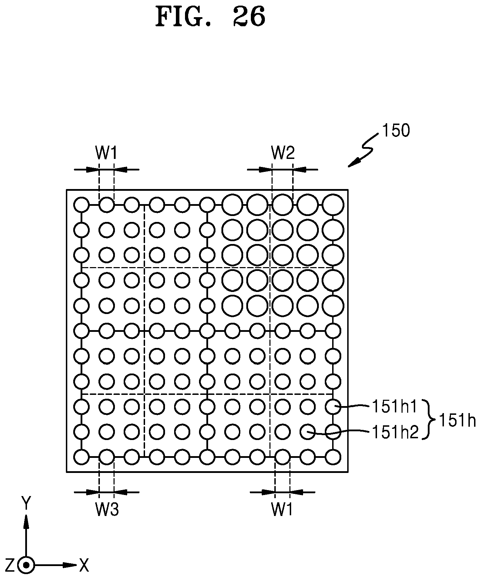

FIG. 26 is a plan view illustrating a configuration of an antireflection layer according to another embodiment. In the above-described embodiment, it has been described that the plurality of holes 151h have the same width or diameter in the entire region of the antireflection layer 150. However, in another embodiment, the width or diameter of each of the plurality of holes 151h of the antireflection layer 150 may vary depending on the position of each of the plurality of holes 151h. Referring to FIG. 26, among the plurality of second holes 151h2, the second hole 151h2 disposed to face the first pixel 111 and the second hole 151h2 disposed to face the fourth pixel 114 in the third direction (Z direction) may have a first width W1. Among the plurality of second holes 151h2, the second hole 151h2 disposed to face the second pixel 112 in the third direction (Z direction) may have a second width W2 different from the first width W1, and the second hole 151h2 disposed to face the third pixel 113 may have a third width W3 different from the first width W1 and the second width W2. For example, the first width W1 may be less than the second width W2, and the third width W3 may be less than the first width W1. Accordingly, the second width W2 of the second hole 151h2 disposed to face the second pixel 112 sensing light of a blue wavelength is the largest, and the third width W3 of the second hole 151h2 disposed to face the third pixel 113 sensing light of a red wavelength may be the smallest. In other words, the length of a wavelength of light sensed by pixels facing each other may be inversely proportional to the width or diameter of the second hole 151h2.

The widths of the plurality of first holes 151h1 disposed in a boundary between two adjacent pixels may be the same as any one of widths of the second holes 151h2 facing the two adjacent pixels. For example, the first hole 151h1 disposed on a boundary between the first pixel 111 and the second pixel 112 may have any width of the first width W1 and the second width W2. Also, the first hole 151h1 disposed on the boundary between the first pixel 111 and the third pixel 113 may have the first width W1 or the third width W3, the first hole 151h1 disposed on a boundary between the third pixel 113 and the fourth pixel 114 may have the third width W3 or the first width W1, and the first hole 151h1 disposed on a boundary between the second pixel 112 and the fourth pixel 114 may have the second width W2 or the first width W1.

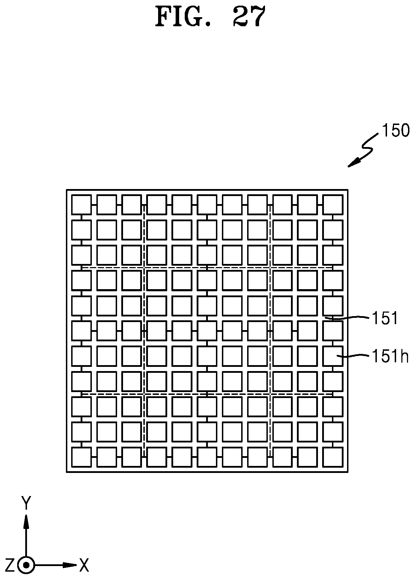

FIG. 27 is a plan view illustrating a configuration of an antireflection layer according to another embodiment. Although the patterned holes 151h are in a circular shape in the above-described embodiment, the disclosure is not limited thereto. For example, as shown in FIG. 27, the holes 151h may be patterned in a rectangular shape. In addition to the rectangular shape, the holes 151h may have other polygonal or elliptical shapes.

As described above, the light use efficiency of the image sensor 1000 may be improved by lowering the overall reflectance of the image sensor 1000 by using the patterned antireflection layer 150. The light use efficiency is improved, and therefore, the size of one pixel of the image sensor 1000 or sizes of independent photosensitive cells in the pixel may be reduced. Accordingly, an image sensor 1000 having a higher resolution may be provided.

The image sensor 1000 according to an embodiment may constitute a camera module together with a module lens having various performances, and may be utilized in various electronic apparatuses.

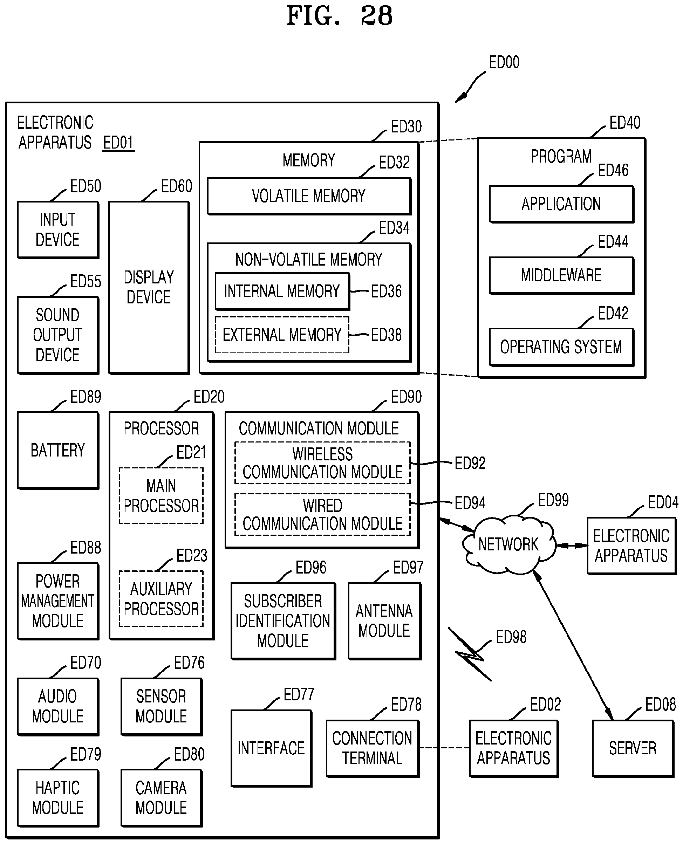

FIG. 28 is a block diagram illustrating an example of an electronic apparatus ED01 including the image sensor 1000. Referring to FIG. 28, in a network environment ED00, the electronic apparatus ED01 may communicate with another electronic apparatus ED02 over a first network ED98 (short-range wireless communication network, etc.), or may communicate with another electronic apparatus ED04 and/or a server ED08 over a second network ED99 (long-range wireless communication network, etc.) The electronic apparatus ED01 may communicate with the electronic apparatus ED04 through the server ED08. The electronic apparatus ED01 may include a processor ED20, a memory ED30, an input device ED50, a sound output device ED55, a display device ED60, an audio module ED70, a sensor module ED76, an interface ED77, a haptic module ED79, a camera module ED80, a power management module ED88, a battery ED89, a communication module ED90, a subscriber identification module ED96, and/or an antenna module ED97. In the electronic apparatus ED01, some (display device ED60, etc.) components may be omitted or another component may be added. Some of the components may be configured as one integrated circuit. For example, the sensor module ED76 (a fingerprint sensor, an iris sensor, an illuminance sensor, etc.) may be embedded and implemented in the display device ED60 (display, etc.)

The processor ED20 may control one or more components (hardware and software components, etc.) of the electronic apparatus ED01 connected to the processor ED20 by executing software (program ED40, etc.), and may perform various data processes or operations. As a part of the data processes or operations, the processor ED20 may load a command and/or data received from another component (sensor module ED76, communication module ED90, etc.) to a volatile memory ED32, may process the command and/or data stored in the volatile memory ED32, and may store result data in a non-volatile memory ED34. The processor ED20 may include a main processor ED21 (central processing unit, application processor, etc.) and an auxiliary processor ED23 (graphic processing unit, image signal processor, sensor hub processor, communication processor, etc.) that may be operated independently from or along with the main processor ED21. The auxiliary processor ED23 may use less power than that of the main processor ED21, and may perform specified functions.

The auxiliary processor ED23, on behalf of the main processor ED21 while the main processor ED21 is in an inactive state (sleep state) or along with the main processor ED21 while the main processor ED21 is in an active state (application executed state), may control functions and/or states related to some (display device ED60, sensor module ED76, communication module ED90, etc.) of the components of the electronic apparatus ED01. The auxiliary processor ED23 (image signal processor, communication processor, etc.) may be implemented as a part of another component (camera module ED80, communication module ED90, etc.) that is functionally related thereto.

The memory ED30 may store various data required by the components (processor ED20, sensor module ED76, etc.) of the electronic apparatus ED01. The data may include, for example, input data and/or output data about software (program ED40, etc.) and commands related thereto. The memory ED30 may include the volatile memory ED32 and/or the non-volatile memory ED34.

The program ED40 may be stored as software in the memory ED30, and may include an operating system ED42, middleware ED44, and/or an application ED46.

The input device ED50 may receive commands and/or data to be used in the components (processor ED20, etc.) of the electronic apparatus ED01, from outside (user, etc.) of the electronic apparatus ED01. The input device ED50 may include a microphone, a mouse, a keyboard, and/or a digital pen (stylus pen).

The sound output device ED55 may output a sound signal to outside of the electronic apparatus ED01. The sound output device ED55 may include a speaker and/or a receiver. The speaker may be used for a general purpose such as multimedia reproduction or record play, and the receiver may be used to receive a call. The receiver may be coupled as a part of the speaker or may be implemented as an independent device.

The display device ED60 may provide visual information to outside of the electronic apparatus ED01. The display device ED60 may include a display, a hologram device, or a projector, and a control circuit for controlling the corresponding device. The display device ED60 may include a touch circuitry set to sense a touch, and/or a sensor circuit (pressure sensor, etc.) that is set to measure a strength of a force generated by the touch.

The audio module ED70 may convert sound into an electrical signal or vice versa. The audio module ED70 may acquire sound through the input device ED50, or may output sound through the sound output device ED55 and/or a speaker and/or a headphone of another electronic apparatus (electronic apparatus ED02, etc.) connected directly or wirelessly to the electronic apparatus ED01.

The sensor module ED76 may sense an operating state (power, temperature, etc.) of the electronic apparatus ED01, or an outer environmental state (user state, etc.), and may generate an electrical signal and/or data value corresponding to the sensed state. The sensor module ED76 may include a gesture sensor, a gyro-sensor, a pressure sensor, a magnetic sensor, an acceleration sensor, a grip sensor, a proximity sensor, a color sensor, an infrared (IR) ray sensor, a vivo sensor, a temperature sensor, a humidity sensor, and/or an illuminance sensor.

The interface ED77 may support one or more designated protocols that may be used in order for the electronic apparatus ED01 to be directly or wirelessly connected to another electronic apparatus (electronic apparatus ED02, etc.) The interface ED77 may include a high-definition multimedia interface (HDMI), a universal serial bus (USB) interface, an SD card interface, and/or an audio interface.

The connection terminal ED78 may include a connector by which the electronic apparatus ED01 may be physically connected to another electronic apparatus (electronic apparatus ED02, etc.). The connection terminal ED78 may include an HDMI connector, a USB connector, an SD card connector, and/or an audio connector (headphone connector, etc.).

The haptic module ED79 may convert the electrical signal into a mechanical stimulation (vibration, motion, etc.) or an electric stimulation that the user may sense through a tactile or motion sensation. The haptic module ED79 may include a motor, a piezoelectric device, and/or an electric stimulus device.

The camera module ED80 may capture a still image and a video. The camera module ED80 may include a lens assembly including one or more lenses, the image sensor 1000 of FIG. 1, image signal processors, and/or flashes. The lens assembly included in the camera module ED80 may collect light emitted from an object that is an object to be captured.

The power management module ED88 may manage the power supplied to the electronic apparatus ED01. The power management module ED88 may be implemented as a part of a power management integrated circuit (PMIC).

The battery ED89 may supply electric power to the components of the electronic apparatus ED01. The battery ED89 may include a primary battery that is not rechargeable, a secondary battery that is rechargeable, and/or a fuel cell.

The communication module ED90 may support the establishment of a direct (wired) communication channel and/or a wireless communication channel between the electronic apparatus ED01 and another electronic apparatus (electronic apparatus ED02, electronic apparatus ED04, server ED08, etc.), and execution of communication through the established communication channel. The communication module ED90 may be operated independently from the processor ED20 (application processor, etc.), and may include one or more communication processors that support the direct communication and/or the wireless communication. The communication module ED90 may include a wireless communication module ED92 (cellular communication module, a short-range wireless communication module, a global navigation satellite system (GNSS) communication module) and/or a wired communication module ED94 (local area network (LAN) communication module, a power line communication module, etc.) From among the communication modules, a corresponding communication module may communicate with another electronic apparatus over a first network ED09 (short-range communication network such as Bluetooth, WiFi direct, or infrared data association (IrDA)) or a second network ED99 (long-range communication network such as a cellular network, Internet, or computer network (LAN, WAN, etc.)). Such above various kinds of communication modules may be integrated as one component (single chip, etc.) or may be implemented as a plurality of components (a plurality of chips) separately from one another. The wireless communication module ED92 may identify and authenticate the electronic apparatus ED01 in a communication network such as the first network ED98 and/or the second network ED99 by using subscriber information (international mobile subscriber identifier (IMSI), etc.) stored in the subscriber identification module ED96.

The antenna module ED97 may transmit or receive the signal and/or power to/from outside (another electronic apparatus, etc.) An antenna may include a radiator formed as a conductive pattern formed on a substrate (PCB, etc.) The antenna module ED97 may include one or more antennas. When the antenna module ED97 includes a plurality of antennas, from among the plurality of antennas, an antenna that is suitable for the communication type used in the communication network such as the first network ED98 and/or the second network ED99 may be selected by the communication module ED90. The signal and/or the power may be transmitted between the communication module ED90 and another electronic apparatus through the selected antenna. Another component (RFIC, etc.) other than the antenna may be included as a part of the antenna module ED97.

Some of the components may be connected to one another by using the communication method among the peripheral devices (bus, general purpose input and output (GPIO), serial peripheral interface (SPI), mobile industry processor interface (MIPI), etc.) and may exchange signals (commands, data, etc.)

The command or data may be transmitted or received between the electronic apparatus ED01 and the external electronic apparatus ED04 through the server ED08 connected to the second network ED99. The other electronic apparatuses ED02 and ED04 may be the same kind as or different kinds from that of the electronic apparatus ED01. All or some of the operations executed by the electronic apparatus ED01 may be executed by one or more apparatuses among the other electronic apparatuses ED02, ED04, and ED08. For example, when the electronic apparatus ED01 has to perform a certain function or service, the electronic apparatus ED01 may request one or more other electronic apparatuses to perform some or entire function or service, instead of executing the function or service by itself. One or more electronic apparatuses receiving the request execute an additional function or service related to the request and may transfer a result of the execution to the electronic apparatus ED01. To this end, cloud computing, distributed computing, or client-server computing technique may be used.

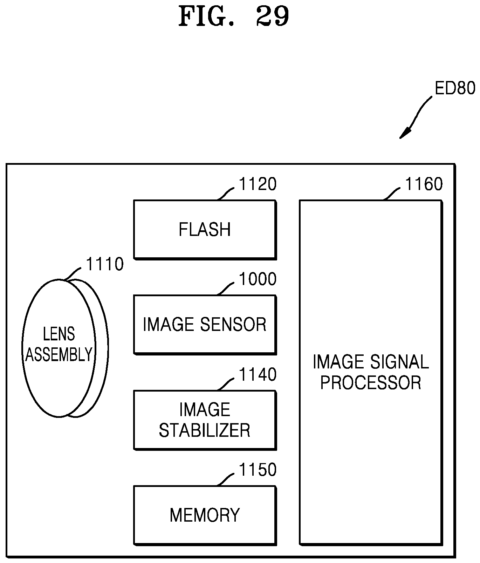

FIG. 29 is a block diagram illustrating the camera module ED80 included in the electronic apparatus ED01 of FIG. 28. Referring to FIG. 29, the camera module ED80 may include a lens assembly 1110, a flash 1120, an image sensor 1000, an image stabilizer 1140, a memory 1150 (buffer memory, etc.), and/or an image signal processor 1160. The lens assembly 1110 may collect light emitted from an object that is to be captured. The camera module ED80 may include a plurality of lens assemblies 1110, and in this case, the camera module ED80 may include a dual camera module, a 360-degree camera, or a spherical camera. Some of the plurality of lens assemblies 1110 may have the same lens properties (viewing angle, focal distance, auto-focus, F number, optical zoom, etc.) or different lens properties. The lens assembly 1110 may include a wide-angle lens or a telephoto lens.

The flash 1120 may emit light that is used to strengthen the light emitted or reflected from the object. The flash 1120 may emit visible light or infrared ray light. The flash 1120 may include one or more light-emitting diodes (red-green-blue (RGB) LED, white LED, infrared LED, ultraviolet LED, etc.), and/or a Xenon lamp. The image sensor 1000 may be the image sensor described above with reference to FIG. 1, and converts the light emitted or reflected from the object and transferred through the lens assembly 1110 into an electrical signal to obtain an image corresponding to the object.

The image stabilizer 1140, in response to a motion of the camera module ED80 or the electronic apparatus 1101 including the camera module ED80, moves one or more lenses included in the lens assembly 1110 or the image sensor 1000 in a certain direction or controls the operating characteristics of the image sensor 1000 (adjusting of a read-out timing, etc.) in order to compensate for a negative influence of the motion. The image stabilizer 1140 may sense the movement of the camera module ED80 or the electronic apparatus ED01 by using a gyro sensor or an acceleration sensor arranged inside or outside the camera module ED80. The image stabilizer 1140 may be implemented as an optical type.

The memory 1150 may store some or entire data of the image obtained through the image sensor 1000 for next image processing operation. For example, when a plurality of images are obtained at a high speed, obtained original data (Bayer-patterned data, high resolution data, etc.) is stored in the memory 1150, and a low resolution image is only displayed. Then, original data of a selected image (user selection, etc.) may be transferred to the image signal processor 1160. The memory 1150 may be integrated with the memory ED30 of the electronic apparatus ED01, or may include an additional memory that operates independently.

The image signal processor 1160 may perform image processing operations on the image obtained through the image sensor 1000 or the image data stored in the memory 1150. The image processing operations may include depth map generation, three-dimensional modeling, panorama generation, extraction of features, an image combination, and/or an image compensation (noise reduction, resolution adjustment, brightness adjustment, blurring, sharpening, softening, etc.). The image signal processor 1160 may perform control operations (exposure time control, read-out timing control, etc.) on the components (image sensor 1000, etc.) included in the camera module ED80. The image processed by the image signal processor 1160 may be stored again in the memory 1150 for additional process, or may be provided to an external component of the camera module ED80 (e.g., the memory ED30, the display device ED60, the electronic apparatus ED02, the electronic apparatus ED04, the server ED08, etc.). The image signal processor 1160 may be integrated with the processor ED20, or may be configured as an additional processor that is independently operated from the processor ED20. When the image signal processor 1160 is configured as an additional processor separately from the processor ED20, the image processed by the image signal processor 1160 may undergo an additional image processing operation by the processor ED20 and then may be displayed on the display device ED60.

Also, the image signal processor 1160 may receive two output signals independently from the adjacent photosensitive cells in each pixel or sub-pixel of the image sensor 1000, and may generate an auto focus signal from a difference between the two output signals. The image signal processor 1160 may control the lens assembly 1110 so that the focus of the lens assembly 1110 may be accurately formed on the surface of the image sensor 1000 based on the auto focus signal.

The electronic apparatus ED01 may further include one or a plurality of camera modules having different properties or functions. The camera module may include components similar to those of the camera module ED80 of FIG. 29, and the image sensor included in the camera module may be implemented as a charge coupled device (CCD) sensor and/or a complementary metal oxide semiconductor (CMOS) sensor and may include one or a plurality of sensors selected from the image sensors having different properties, such as an RGB sensor, a black and white (BW) sensor, an IR sensor, or a UV sensor. In this case, one of the plurality of camera modules ED80 may include a wide-angle camera and another camera module ED80 may include a telephoto camera. Similarly, one of the plurality of camera modules ED80 may include a front camera and another camera module ED80 may include a rear camera.

The image sensor having the patterned antireflection layer and the electronic apparatus including the image sensor have been described above with reference to the embodiments shown in the drawings, but these are merely exemplary, and it will be understood by those of ordinary skill in the art that various modifications and other equivalent embodiments therefrom are possible. Therefore, the disclosed embodiments should be considered in descriptive sense only and not for purposes of limitation. Therefore, the scope of the disclosure is defined not by the detailed description of the disclosure but by the appended claims, and all differences within the scope will be construed as being included in the disclosure.

According to the disclosed embodiment, the light use efficiency of the image sensor may be improved by using the patterned antireflection layer. The light use efficiency is improved, and therefore, the size of one pixel of the image sensor or sizes of independent photosensitive cells in the pixel may be reduced. Accordingly, the image sensor having a higher resolution may be provided.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. An image sensor comprising:
a sensor substrate comprising a plurality of first pixels configured to sense light having a first wavelength and a plurality of second pixels configured to sense light having a second wavelength that is different from the first wavelength;
a nano-photonic lens array having a light incident surface and comprising a plurality of nanostructures configured to condense an incident light onto the plurality of first pixels and the plurality of second pixels; and **characterised in that**
an antireflection layer is disposed on the light incident surface of the nano-photonic lens array and comprising a plurality of holes arranged periodically and two-dimensionally,
wherein the plurality of holes comprises:
a plurality of first holes provided at positions corresponding to a boundary between first pixels, among the plurality of first pixels, and second pixels, among the plurality of second pixels, that are adjacent to the first pixels; and
a plurality of second holes facing an inner region of at least one of a first pixel of the plurality of first pixels or a second pixel of the plurality of second pixels.

2. The image sensor of claim 1, wherein a center of each of the plurality of first holes is positioned above the boundary between the first pixels and second pixels that are adjacent to the first pixels.

3. The image sensor of claim 1 or 2, wherein each of the plurality of holes has a same width.

4. The image sensor of claim 1 or 2, wherein a second hole facing the first pixel, among the plurality of second holes, has a first width,
wherein a second hole facing the second pixel, among the plurality of second holes, has a second width different from the first width, and
wherein the plurality of first holes have the first width or the second width, and optionally wherein a distance between adjacent holes of the plurality of holes is the same.

5. The image sensor of claim 4, wherein the first wavelength is greater than the second wavelength, and the first width is less than the second width.

6. The image sensor of any preceding claim, wherein an average refractive index of the antireflection layer is greater than a refractive index of air and less than an average refractive index of the nano-photonic lens array.

7. The image sensor of any preceding claim, wherein the antireflection layer comprises:
a first antireflection layer disposed on the light incident surface of the nano-photonic lens array; and
a second antireflection layer disposed on the first antireflection layer, and
wherein the second antireflection layer is patterned to include the plurality of holes, and optionally wherein the first antireflection layer has a first refractive index, the second antireflection layer has a second refractive index, and the first refractive index is higher than the second refractive index.

8. The image sensor of claim 7, wherein the first antireflection layer is at least partially patterned to include the plurality of holes.

9. The image sensor of any preceding claim, wherein the antireflection layer comprises an inorganic material having a refractive index that is equal to or greater than 1 and equal to or less than 3.

10. The image sensor of any preceding claim, wherein the nano-photonic lens array comprises a plurality of first lenses facing the plurality of first pixels and a plurality of second lenses facing the plurality of second pixels, and
the plurality of nanostructures are configured to condense light of the first wavelength among an incident light incident on a first lens among the plurality of lenses and an incident light incident on at least part of a second lens among the plurality of lenses to a first pixel, and condense light of the second wavelength among an incident light incident on the second lens and an incident light incident on at least part of the first lens to a second pixel.

11. The image sensor of any preceding claim, further comprising:
a color filter layer disposed between the sensor substrate and the nano-photonic lens array; and
a planarization layer disposed between the color filter layer and the nano-photonic lens array.

12. The image sensor of any preceding claim, wherein each of the plurality of first pixels and the plurality of second pixels comprises a plurality of photosensitive cells grouped in a first direction and a second direction perpendicular to the first direction, arranged two-dimensionally, and independently sensing the incident light, and
wherein the sensor substrate comprises an isolation layer electrically isolating the plurality of photosensitive cells from one another, and optionally wherein the plurality of second holes are arranged so as not to face the isolation layer.

13. The image sensor of any preceding claim, wherein each respective first pixel of the plurality of first pixels and each respective second pixel of the plurality of second pixels comprises the inner region and an outer edge region, and
wherein the plurality of first pixels and the plurality of second pixels are arranged so that an at least one first pixel of the plurality of first pixels is adjacent to at least one second pixel of the plurality of second pixels such that the edge region of the at least one first pixel and the edge region of the at least one second pixel form the boundary.

14. The image sensor of claim 13, wherein an at least one first hole, among the plurality of first holes, face the boundary.

15. An electronic apparatus comprising:
a lens assembly configured to form an optical image of a subject;
an image sensor according to any preceding claim configured to convert the optical image formed by the lens assembly into an electrical signal; and
a processor configured to process the electrical signal generated by the image sensor.

## Patentansprüche

1. Bildsensor, umfassend:
ein Sensorsubstrat, das eine Vielzahl von ersten Pixeln, die zum Erfassen von Licht mit einer ersten Wellenlänge konfiguriert sind, und eine Vielzahl von zweiten Pixeln, die zum Erfassen von Licht mit einer zweiten Wellenlänge konfiguriert sind, die sich von der ersten Wellenlänge unterscheidet, umfasst;
ein nanophotonisches Linsenarray, das eine Lichteinfallsfläche aufweist und eine Vielzahl von Nanostrukturen umfasst, die dazu konfiguriert sind, einfallendes Licht auf die Vielzahl von ersten Pixeln und die Vielzahl von zweiten Pixeln zu konzentrieren; und **dadurch gekennzeichnet, dass**
eine Antireflexionsschicht auf der Lichteinfallsfläche des nanophotonischen Linsenarrays angeordnet ist und eine Vielzahl von periodisch und zweidimensional platzierten Löchern umfassend,
wobei die Vielzahl von Löchern Folgendes umfasst:
eine Vielzahl von ersten Löchern, die an Positionen bereitgestellt sind, die einer Grenze zwischen ersten Pixeln unter der Vielzahl von ersten Pixeln und zweiten Pixeln unter der Vielzahl von zweiten Pixeln, die an die ersten Pixel angrenzen, entsprechen; und
eine Vielzahl von zweiten Löchern, die einem inneren Bereich von mindestens einem von einem ersten Pixel der Vielzahl von ersten Pixeln oder einem zweiten Pixel der Vielzahl von zweiten Pixeln zugewandt sind.

2. Bildsensor nach Anspruch 1, wobei ein Mittelpunkt jedes der Vielzahl von ersten Löchern über der Grenze zwischen den ersten Pixeln und den zweiten Pixeln, die an die ersten Pixel angrenzen, positioniert ist.

3. Bildsensor nach Anspruch 1 oder 2, wobei jedes der Vielzahl von Löchern eine gleiche Breite aufweist.

4. Bildsensor nach Anspruch 1 oder 2, wobei ein zweites Loch, das dem ersten Pixel zugewandt ist, unter der Vielzahl von zweiten Löchern eine erste Breite aufweist,
wobei ein zweites Loch, das dem zweiten Pixel zugewandt ist, unter der Vielzahl von zweiten Löchern eine zweite Breite aufweist, die sich von der ersten Breite unterscheidet, und
wobei die Vielzahl von ersten Löchern die erste Breite oder die zweite Breite aufweisen und wobei optional ein Abstand zwischen angrenzenden Löchern der Vielzahl von Löchern gleich ist.

5. Bildsensor nach Anspruch 4, wobei die erste Wellenlänge größer als die zweite Wellenlänge ist und die erste Breite kleiner als die zweite Breite ist.

6. Bildsensor nach einem vorhergehenden Anspruch, wobei ein durchschnittlicher Brechungsindex der Antireflexionsschicht größer als ein Brechungsindex von Luft und kleiner als ein durchschnittlicher Brechungsindex des nanophotonischen Linsenarrays ist.

7. Bildsensor nach einem vorhergehenden Anspruch, wobei die Antireflexionsschicht Folgendes umfasst:
eine erste Antireflexionsschicht, die auf der Lichteinfallsfläche des nanophotonischen Linsenarrays angeordnet ist; und
eine zweite Antireflexionsschicht, die auf der ersten Antireflexionsschicht angeordnet ist, und
wobei die zweite Antireflexionsschicht so strukturiert ist, dass sie die Vielzahl von Löchern enthält, und wobei optional die erste Antireflexionsschicht einen ersten Brechungsindex aufweist, die zweite Antireflexionsschicht einen zweiten Brechungsindex aufweist und der erste Brechungsindex höher als der zweite Brechungsindex ist.

8. Bildsensor nach Anspruch 7, wobei die erste Antireflexionsschicht mindestens teilweise so strukturiert ist, dass sie die Vielzahl von Löchern enthält.

9. Bildsensor nach einem vorhergehenden Anspruch, wobei die Antireflexionsschicht ein anorganisches Material mit einem Brechungsindex umfasst, der gleich oder größer als 1 und gleich oder kleiner als 3 ist.

10. Bildsensor nach einem vorhergehenden Anspruch, wobei das nanophotonische Linsenarray eine Vielzahl von ersten Linsen, die der Vielzahl von ersten Pixeln zugewandt sind, und eine Vielzahl von zweiten Linsen umfasst, die der Vielzahl von zweiten Pixeln zugewandt sind, und
die Vielzahl von Nanostrukturen dazu konfiguriert sind, Licht der ersten Wellenlänge aus einem Einfallslicht, das auf eine erste Linse unter der Vielzahl von Linsen einfällt, und einem Einfallslicht, das auf mindestens einen Teil einer zweiten Linse unter der Vielzahl von Linsen einfällt, auf ein erstes Pixel zu konzentrieren, und Licht der zweiten Wellenlänge aus einem Einfallslicht, das auf die zweite Linse einfällt, und einem Einfallslicht, das auf mindestens einen Teil der ersten Linse einfällt, auf ein zweites Pixel zu konzentrieren.

11. Bildsensor nach einem vorhergehenden Anspruch, ferner umfassend:
eine Farbfilterschicht, die zwischen dem Sensorsubstrat und dem nanophotonischen Linsenarray angeordnet ist; und
eine Planarisierungsschicht, die zwischen der Farbfilterschicht und dem nanophotonischen Linsenarray angeordnet ist.

12. Bildsensor nach einem vorhergehenden Anspruch, wobei jedes der Vielzahl von ersten Pixeln und der Vielzahl von zweiten Pixeln eine Vielzahl von photosensitiven Zellen umfasst, die in einer ersten Richtung und einer zweiten Richtung, die senkrecht zu der ersten Richtung ist, gruppiert sind, zweidimensional platziert sind und das einfallende Licht unabhängig voneinander erfassen, und
wobei das Sensorsubstrat eine Isolationsschicht umfasst, die die Vielzahl von photosensitiven Zellen elektrisch voneinander isoliert, und wobei optional die Vielzahl zweiter Löcher so platziert sind, dass sie nicht der Isolationsschicht zugewandt sind.

13. Bildsensor nach einem vorhergehenden Anspruch, wobei jedes jeweilige erste Pixel der Vielzahl von ersten Pixeln und jedes jeweilige zweite Pixel der Vielzahl von zweiten Pixeln den inneren Bereich und einen äußeren Randbereich umfasst, und
wobei die Vielzahl von ersten Pixeln und die Vielzahl von zweiten Pixeln so platziert sind, dass mindestens ein erstes Pixel der Vielzahl von ersten Pixeln an mindestens ein zweites Pixel der Vielzahl von zweiten Pixeln angrenzt, sodass der Randbereich des mindestens einen ersten Pixels und der Randbereich des mindestens einen zweiten Pixels die Grenze bilden.

14. Bildsensor nach Anspruch 13, wobei mindestens ein erstes Loch unter der Vielzahl von ersten Löchern der Grenze zugewandt ist.

15. Elektronische Vorrichtung, umfassend:
eine Linsenanordnung, die dazu konfiguriert ist, ein optisches Bild eines Subjekts auszubilden;
einen Bildsensor gemäß einem vorhergehenden Anspruch, der dazu konfiguriert ist, das optische Bild, das durch die Linsenanordnung ausgebildet wird, in ein elektrisches Signal umzuwandeln; und
einen Prozessor, der zum Verarbeiten des durch den Bildsensor erzeugten elektrischen Signals konfiguriert ist.

## Revendications

1. Capteur d'image comprenant :
un substrat de capteur comprenant une pluralité de premiers pixels configurés pour détecter la lumière comportant une première longueur d'onde et une pluralité de seconds pixels configurés pour détecter la lumière comportant une seconde longueur d'onde qui est différente de la première longueur d'onde ;
un réseau de lentilles nano-photoniques comportant une surface d'incidence de lumière et comprenant une pluralité de nanostructures configurées pour condenser une lumière incidente sur la pluralité de premiers pixels et la pluralité de seconds pixels ; et **caractérisé en ce que**
une couche antireflet est
disposée sur la surface d'incidence de lumière du réseau de lentilles nano-photoniques et comprenant une pluralité de trous agencés périodiquement et en deux dimensions,
ladite pluralité de trous comprenant :
une pluralité de premiers trous prévus au niveau des positions correspondant à une limite entre des premiers pixels, parmi la pluralité de premiers pixels, et des seconds pixels, parmi la pluralité de seconds pixels, qui sont adjacents aux premiers pixels ; et
une pluralité de seconds trous faisant face à une zone interne d'au moins l'un d'un premier pixel de la pluralité de premiers pixels ou d'un second pixel de la pluralité de seconds pixels.

2. Capteur d'image de la revendication 1, un centre de chacun de la pluralité de premiers trous étant positionné au-dessus de la frontière entre les premiers pixels et les seconds pixels qui sont adjacents aux premiers pixels.

3. Capteur d'image de la revendication 1 ou 2, chacun de la pluralité de trous comportant une même largeur.

4. Capteur d'image de la revendication 1 ou 2, un second trou faisant face au premier pixel, parmi la pluralité de seconds trous, comportant une première largeur,
un second trou faisant face au second pixel, parmi la pluralité de seconds trous, comportant une seconde largeur différente de la première largeur, et
ladite pluralité de premiers trous comportant la première largeur ou la seconde largeur, et éventuellement une distance entre des trous adjacents de la pluralité de trous étant la même.

5. Capteur d'image de la revendication 4, ladite première longueur d'onde étant supérieure à la seconde longueur d'onde, et ladite première largeur étant inférieure à la seconde largeur.

6. Capteur d'image d'une quelconque revendication précédente, un indice de réfraction moyen de la couche antireflet étant supérieur à un indice de réfraction de l'air et inférieur à un indice de réfraction moyen du réseau de lentilles nano-photoniques.

7. Capteur d'image d'une quelconque revendication précédente, ladite couche antireflet comprenant :
une première couche antireflet disposée sur la surface d'incidence de lumière du réseau de lentilles nano-photoniques ; et
une seconde couche antireflet disposée sur la première couche antireflet, et
ladite seconde couche antireflet étant à motifs pour comprendre la pluralité de trous, et éventuellement ladite première couche antireflet comportant un premier indice de réfraction, ladite seconde couche antireflet comportant un second indice de réfraction, et ledit premier indice de réfraction étant supérieur audit second indice de réfraction.

8. Capteur d'image de la revendication 7, ladite première couche antireflet étant au moins partiellement à motifs pour comprendre ladite pluralité de trous.

9. Capteur d'image d'une quelconque revendication précédente, ladite couche antireflet comprenant un matériau inorganique comportant un indice de réfraction qui est supérieur ou égal à 1 et inférieur ou égal à 3.

10. Capteur d'image d'une quelconque revendication précédente, ledit réseau de lentilles nano-photoniques comprenant une pluralité de premières lentilles faisant face à la pluralité de premiers pixels et une pluralité de secondes lentilles faisant face à la pluralité de seconds pixels, et
la pluralité de nanostructures étant configurées pour condenser la lumière de la première longueur d'onde parmi une lumière incidente qui est incidente sur une première lentille parmi la pluralité de lentilles et une lumière incidente qui est incidente sur au moins une partie d'une seconde lentille parmi la pluralité de lentilles vers un premier pixel, et condenser la lumière de la seconde longueur d'onde parmi une lumière incidente qui est incidente sur la seconde lentille et une lumière incidente qui est incidente sur au moins une partie de la première lentille vers un second pixel.

11. Procédé d'une quelconque revendication précédente, comprenant en outre :
une couche de filtre coloré disposée entre le substrat de capteur et le réseau de lentilles nano-photoniques ; et
une couche de planarisation disposée entre la couche de filtre coloré et le réseau de lentilles nano-photoniques.

12. Capteur d'image d'une quelconque revendication précédente, chacun de la pluralité de premiers pixels et de la pluralité de seconds pixels comprenant une pluralité de cellules photosensibles regroupées dans une première direction et une seconde direction perpendiculaire à la première direction, agencées en deux dimensions et détectant indépendamment la lumière incidente, et
ledit substrat de capteur comprenant une couche d'isolation isolant électriquement la pluralité de cellules photosensibles les unes des autres, et éventuellement ladite pluralité de seconds trous étant agencés de façon à ne pas faire face à la couche d'isolation.

13. Capteur d'image d'une quelconque revendication précédente, chaque premier pixel respectif de la pluralité de premiers pixels et chaque second pixel respectif de la pluralité de seconds pixels comprenant la zone interne et une zone de bord externe, et
ladite pluralité de premiers pixels et ladite pluralité de seconds pixels étant agencés afin qu'un au moins un premier pixel de la pluralité de premiers pixels soit adjacent à au moins un second pixel de la pluralité de seconds pixels de sorte que la zone de bord de l'au moins un premier pixel et la zone de bord de l'au moins un second pixel forment la limite.

14. Capteur d'image de la revendication 13, au moins un premier trou, parmi la pluralité de premiers trous, faisant face à la limite.

15. Appareil électronique comprenant :
un ensemble lentille configuré pour former une image optique d'un sujet ;
un capteur d'image d'une quelconque revendication précédente configuré pour convertir l'image optique formée en un signal électrique ; et
un processeur configuré pour traiter le signal électrique généré par le capteur d'image.
